# EUROPEAN PATENT APPLICATION

(11) **EP 4 362 066 A1**
(43) Date of publication of application: **01.05.2024**
(21) Application number: 23189698.6
(22) Date of filing: 04.08.2023
(51) Int. Cl.: H01L 21/02, H01L 21/306

(54) **MANUFACTURING METHOD OF SEMICONDUCTOR ELEMENT, SEMICONDUCTOR LAYER SUPPORT STRUCTURE, AND SEMICONDUCTOR SUBSTRATE**

(30) Priority: 28.10.2022 JP 2022173002
(71) Applicant: Oki Electric Industry Co., Ltd., Minato-ku Tokyo 105-8460 (JP)
(72) Inventor: JUMONJI, Shinya, Tokyo, 105-8460 (JP); KOSAKA, Toru, Tokyo, 105-8460 (JP); SUZUKI, Takahito, Tokyo, 105-8460 (JP); TANIGAWA, Kenichi, Tokyo, 105-8460 (JP); NAKAI, Yusuke, Tokyo, 105-8460 (JP); KAWADA, Hiroto, Tokyo, 105-8460 (JP); MATSUO, Genichirou, Tokyo, 105-8460 (JP); KITAJIMA, Yutaka, Tokyo, 105-8460 (JP)
(74) Representative: Betten & Resch

(57) **Abstract**

A manufacturing method of a semiconductor element includes forming a plurality of semiconductor layers (12) on a sapphire substrate (11), each of the semiconductor layers (12) having a first surface (12s) on the sapphire substrate (11) side and a second surface (12t) on the opposite side, joining the second surfaces (12t) of the plurality of semiconductor layers (12) to a retention member (15) via an adhesive member (14), peeling off the plurality of semiconductor layers (12) from the sapphire substrate (11) by irradiating the first surfaces (12s) of the plurality of semiconductor layers (12) with laser light, and polishing the first surfaces (12s) of the plurality of semiconductor layers (12). At least one semiconductor layer (12) among the plurality of semiconductor layers (12) includes a polishing indication part (12h) extending from the second surface (12t) toward the first surface (12s). The polishing is executed until the polishing indication part (12h) is exposed to the polished surface.

## Description

### BACKGROUND OF THE INVENTION

### 1. Field of the Invention

The present disclosure relates to a manufacturing method of a semiconductor element, a semiconductor layer support structure, and a semiconductor substrate.

### 2. Description of the Related Art

Conventionally, there has been known a technology of flattening a surface of a semiconductor layer by means of polishing (see Patent Reference 1, for example).

Patent Reference 1: Japanese Patent Application Publication No. 2006-86388 (see ABSTRACT)

### SUMMARY OF THE INVENTION

However, it is difficult in the polishing process to precisely control a finish thickness of the semiconductor layer.

The object of the present disclosure is to make it possible to precisely control the finish thickness of the semiconductor layer in the polishing process.

A manufacturing method of a semiconductor element in the present disclosure includes a process of forming a plurality of semiconductor layers on a sapphire substrate, each of the plurality of semiconductor layers having a first surface on the sapphire substrate side and a second surface on the opposite side, a joining process of joining the second surfaces of the plurality of semiconductor layers to a retention member via an adhesive member, a peeling process of peeling off the plurality of semiconductor layers from the sapphire substrate by irradiating the first surfaces of the plurality of semiconductor layers with laser light, and a polishing process of polishing the first surfaces of the plurality of semiconductor layers. At least one semiconductor layer among the plurality of semiconductor layers includes a polishing indication part extending from the second surface toward the first surface. In the polishing process, the polishing is executed until the polishing indication part is exposed to the polished surface.

According to the present disclosure, the polishing can be executed while checking whether or not the polishing indication part is exposed to the polished surface, and thus the finish thickness of the semiconductor layer can be controlled precisely.

### BRIEF DESCRIPTION OF THE DRAWINGS

FIG. 1 is a flowchart showing a manufacturing method of a semiconductor element in a first embodiment.
FIGS. 2(A) and 2(B) are a perspective view and a cross-sectional view schematically showing a state in which a semiconductor thin-film layer has been formed on a sapphire substrate in the manufacturing method of the semiconductor element in the first embodiment.
FIG. 3 is a plan view schematically showing semiconductor layers separated on the sapphire substrate in the manufacturing method of the semiconductor element in the first embodiment.
FIG. 4 is a perspective view schematically showing the shape of the semiconductor layer in the manufacturing method of the semiconductor element in the first embodiment.
FIGS. 5(A) and 5(B) are cross-sectional views schematically showing a process of singulating the semiconductor thin-film layer and a process of forming holes in the manufacturing method of the semiconductor element in the first embodiment.
FIG. 6 is a cross-sectional view schematically showing a state in which the semiconductor layers have been joined to a glass substrate via an adhesive member in the manufacturing method of the semiconductor element in the first embodiment.
FIGS. 7(A) and 7(B) are cross-sectional views schematically showing configuration examples of the adhesive member in FIG. 6.
FIGS. 8(A), 8(B) and 8(C) are cross-sectional views schematically showing a process of peeling off the semiconductor layers from the sapphire substrate in the manufacturing method of the semiconductor element in the first embodiment.
FIGS. 9(A) and 9(B) are a cross-sectional view and a perspective view schematically showing a process of polishing the semiconductor layers in the manufacturing method of the semiconductor element in the first embodiment.
FIGS. 10(A), 10(B) and 10(C) are cross-sectional views schematically showing a method of controlling a finish thickness of the semiconductor layer in the manufacturing method of the semiconductor element in the first embodiment.
FIG. 11 is a cross-sectional view schematically showing a semiconductor layer support structure in the manufacturing method of the semiconductor element in the first embodiment.
FIGS. 12(A) and 12(B) are cross-sectional views schematically showing a process of joining the semiconductor layer to a silicon substrate and a process of removing the adhesive member in the manufacturing method of the semiconductor element in the first embodiment.
FIG. 13 is a plan view schematically showing semiconductor layers separated on the sapphire substrate in a manufacturing method of a semiconductor element in a second embodiment.
FIG. 14 is a plan view showing the adhesive member on the semiconductor layers in the manufacturing method of the semiconductor element in the second embodiment.
FIGS. 15(A) and 15(B) are a cross-sectional view and a perspective view schematically showing a process of polishing the semiconductor layers in the manufacturing method of the semiconductor element in the second embodiment.
FIG. 16 is a flowchart showing a manufacturing method of a semiconductor element in a third embodiment.
FIG. 17 is a plan view showing the semiconductor layers separated on the sapphire substrate in the manufacturing method of the semiconductor element in the third embodiment.
FIG. 18 is a plan view showing supports on the semiconductor layers in the manufacturing method of the semiconductor element in the third embodiment.
FIGS. 19(A), 19(B) and 19(C) are cross-sectional views schematically showing a process of forming the holes of the semiconductor layers, a process of forming a support layer and a process of singulating the support layer in the manufacturing method of the semiconductor element in the third embodiment.
FIG. 20 is a cross-sectional view schematically showing a state in which the supports have been joined to the glass substrate via the adhesive member in the manufacturing method of the semiconductor element in the third embodiment.
FIGS. 21(A) and 21(B) are cross-sectional views schematically showing configuration examples of the adhesive member in FIG. 20.
FIGS. 22(A), 22(B) and 22(C) are cross-sectional views schematically showing a process of peeling off the semiconductor layers from the sapphire substrate in the manufacturing method of the semiconductor element in the third embodiment.
FIGS. 23(A) and 23(B) are a cross-sectional view and a perspective view schematically showing a process of polishing the semiconductor layers in the manufacturing method of the semiconductor element in the third embodiment.
FIG. 24 is a cross-sectional view schematically showing a semiconductor layer support structure in the manufacturing method of the semiconductor element in the third embodiment.
FIGS. 25(A), 25(B) and 25(C) are cross-sectional views showing a process of joining the semiconductor layer to the silicon substrate, a process of removing the adhesive member and a process of removing the support in the manufacturing method of the semiconductor element in the third embodiment.
FIG. 26 is a diagram schematically showing another example of the process of polishing the semiconductor layers in the semiconductor element in the third embodiment.
FIG. 27 is a flowchart showing a manufacturing method of a semiconductor element in a fourth embodiment.
FIG. 28 is a plan view schematically showing semiconductor layers separated on the sapphire substrate in the manufacturing method of the semiconductor element in the fourth embodiment.
FIG. 29 is a perspective view schematically showing the shape of the semiconductor layer in the manufacturing method of the semiconductor element in the fourth embodiment.
FIG. 30 is a perspective view schematically showing the shapes of the semiconductor layer and a support in the manufacturing method of the semiconductor element in the fourth embodiment.
FIGS. 31(A), 31(B) and 31(C) are cross-sectional views schematically showing a process of forming cutout parts of the semiconductor layer, a process of forming a support layer and a process of singulating the support layer in the manufacturing method of the semiconductor element in the fourth embodiment.
FIGS. 32(A), 32(B) and 32(C) are cross-sectional views schematically showing a process of peeling off the semiconductor layers from the sapphire substrate in the manufacturing method of the semiconductor element in the fourth embodiment.
FIGS. 33(A) and 33(B) are a cross-sectional view and a perspective view schematically showing a process of polishing the semiconductor layers in the manufacturing method of the semiconductor element in the fourth embodiment.
FIG. 34 is a cross-sectional view schematically showing a semiconductor layer support structure in the manufacturing method of the semiconductor element in the fourth embodiment.
FIGS. 35(A), 35(B) and 35(C) are cross-sectional views showing a process of joining the semiconductor layer to the silicon substrate, a process of removing the adhesive member and a process of removing the support in the manufacturing method of the semiconductor element in the fourth embodiment.

### DETAILED DESCRIPTION OF THE INVENTION

A manufacturing method of a semiconductor element according to each embodiment and a semiconductor layer support structure and a semiconductor substrate used for the manufacture of the semiconductor element will be described below with reference to the drawings. The following embodiments are just examples and a variety of modifications are possible within the scope of the present disclosure.

### (First Embodiment)

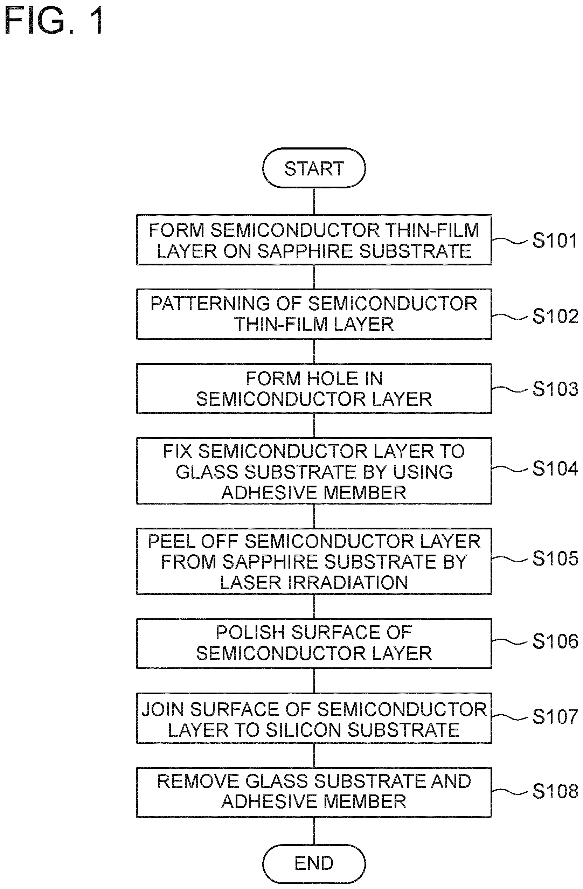

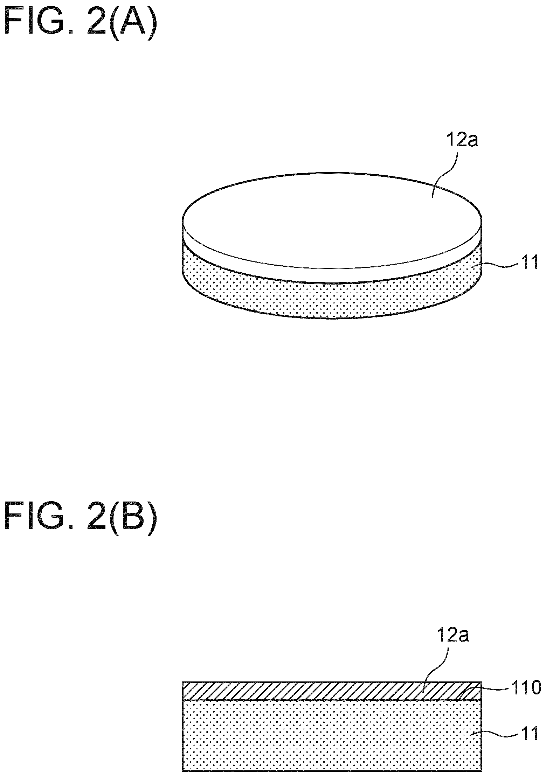

FIG. 1 is a flowchart showing a manufacturing method of a semiconductor element in a first embodiment. In step S101 shown in FIG. 1, a semiconductor thin-film layer 12a is formed on a sapphire substrate 11 as a growth substrate. FIGS. 2(A) and 2(B) are a perspective view and a cross-sectional view schematically showing a state in which the semiconductor thin-film layer 12a has been formed on the sapphire substrate 11.

### <Process of Forming Semiconductor Thin-film Layer>

The sapphire substrate 11 is a growth substrate on whose surface the semiconductor thin-film layer 12a is grown epitaxially, and is a wafer in a circular shape in this example. Incidentally, it is also possible to use a growth substrate other than a sapphire substrate as long as the semiconductor thin-film layer 12a can be grown epitaxially on the substrate.

The semiconductor thin-film layer 12a is a layer made of a nitride semiconductor, more specifically, a layer made of GaN (gallium nitride). The semiconductor thin-film layer 12a can be formed by epitaxially growing a monocrystalline GaN layer on the sapphire substrate 11. Incidentally, the semiconductor thin-film layer 12a is not limited to a layer made of a nitride semiconductor but may further contain a semiconductor other than a nitride semiconductor.

For use as LEDs (Light-Emitting Diodes), the semiconductor thin-film layer 12a may be formed as a stacked structure obtained by stacking a buffer layer, an n-type GaN layer, an n-type AlGaN layer, an InGaN layer, a p-type AlGaN layer and a p-type GaN layer, for example.

### <Process of singulating Semiconductor Thin-film Layer and Process of Forming Holes>

In the subsequent step S102 (FIG. 1), the semiconductor thin-film layer 12a on the sapphire substrate 11 is patterned by means of photolithography and thereby separated (singulated) into a plurality of semiconductor layers 12. Incidentally, the semiconductor layer 12 is referred to also as a semiconductor thin film (or a semiconductor thin film piece).

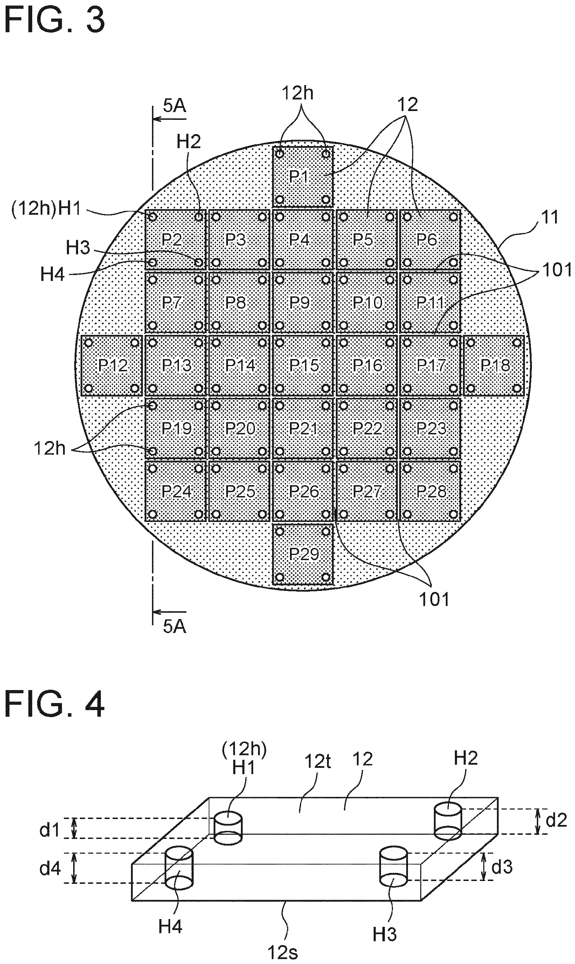

FIG. 3 is a plan view showing the semiconductor layers 12 after the separation. The semiconductor layers 12 are separated in a grid pattern by grooves 101 extending in two directions orthogonal to each other. The shape of the semiconductor layer 12 is a quadrangular shape, more specifically, a square shape with each side 1 mm to 10 mm long. However, the shape of the semiconductor layer 12 is not limited to the square shape but may be a rectangular shape or a different shape.

In the example shown in FIG. 3, twenty-nine semiconductor layers 12 are arrayed on the sapphire substrate 11 to form chip parts P1 to P29. Among these chip parts, twenty-five chip parts P2 to P11, P13 to P17 and P19 to P28 are formed in five rows and five columns. Further, chip parts P1, P12, P18 and P29 are formed respectively on an outer peripheral side of the center (chip part P4) of the first row, the center (chip part P13) of the first column, the center (chip part P17) of the fifth column and the center (chip part P26) of the fifth row. However, the number and arrangement of the chip parts are not limited to this example.

FIG. 4 is a perspective view schematically showing the shape of one semiconductor layer 12. The semiconductor layer 12 has a first surface 12s on the sapphire substrate 11 side and a second surface 12t on the opposite side.

The semiconductor layer 12 includes holes 12h as polishing indication parts extending from the second surface 12t toward the first surface 12s. The extending direction of the hole 12h is a direction orthogonal to the first surface 12s and the second surface 12t, for example. The hole 12h has a depth not to reach the first surface 12s. While the cross-sectional shape of the hole 12h is a circular shape in this example, the cross-sectional shape may be a different shape.

In this example, the holes 12h are respectively formed in the vicinity of four corners of the semiconductor layer 12. The four holes 12h (represented by reference characters H1, H2, H3 and H4) respectively have depths d1, d2, d3 and d4 from the second surface 12t.

The depths d1, d2, d3 and d4 of the four holes 12h may be all the same. Alternatively, the depth of one hole 12h may differ from the depth of another hole 12h. Further, the depths d1, d2, d3 and d4 of the holes 12h may satisfy d1 < d2 < d3 < d4, for example.

Incidentally, while each of semiconductor layers 12 (P1 to P29) shown in FIG. 3 includes the holes 12h in this example, it is sufficient that at least one semiconductor layer 12 includes the holes 12h. Further, the one semiconductor layer 12 does not need to include four holes 12h. It is sufficient that the one semiconductor layer 12 includes at least one hole 12h.

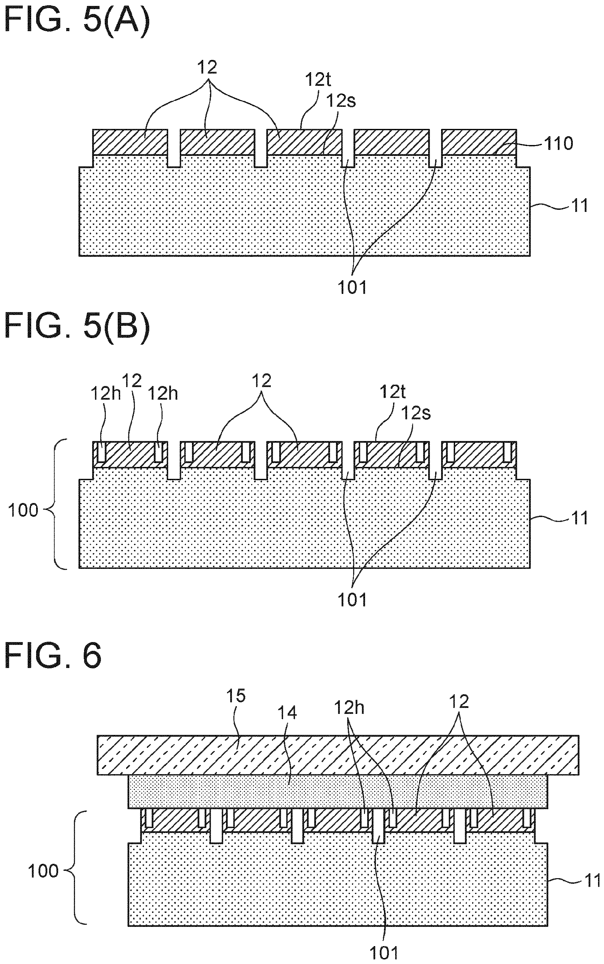

FIGS. 5(A) and 5(B) are cross-sectional views schematically showing the process of separating (singulating) the semiconductor thin-film layer 12a on the sapphire substrate 11 and the process of forming the holes 12h in the semiconductor layer 12. FIGS. 5(A) and 5(B) correspond to cross-sectional views taken along the line 5A - 5A shown in FIG. 3.

After separating the semiconductor thin-film layer 12a into a plurality of semiconductor layers 12 as shown in FIG. 5(A), the holes 12h are formed in the semiconductor layers 12 as shown in FIG. 5(B) in step S103 (FIG. 1). The holes 12h can be formed by means of photolithography, for example.

By this process, a semiconductor substrate 100 including the sapphire substrate 11 and a plurality of semiconductor layers 12 formed on the sapphire substrate 11 is formed.

### <Process of Joining to Glass Substrate>

In the subsequent step S104 (FIG. 1), the semiconductor layers 12 are joined to a glass substrate 15 as a retention member via an adhesive member 14. FIG. 6 is a cross-sectional view schematically showing a state in which the semiconductor layers 12 have been joined to the glass substrate 15 via the adhesive member 14.

The glass substrate 15 is the retention member that holds the sapphire substrate 11 and the semiconductor layers 12. Incidentally, a retention member made of a different material may be used instead of the glass substrate as long as the member has sufficient strength and solvent resistance required for the retention member.

The adhesive member 14 is softer than the semiconductor layer 12. Part or the whole of the adhesive member 14 is formed of an adhesive layer which will be described later, and the adhesive layer has viscoelasticity. When the semiconductor layer 12 and the adhesive member 14 receive a load in a stacking direction of the semiconductor layer 12 and the adhesive member 14 via the glass substrate 15 and the like, the adhesive member 14 is more likely to deform than the semiconductor layer 12.

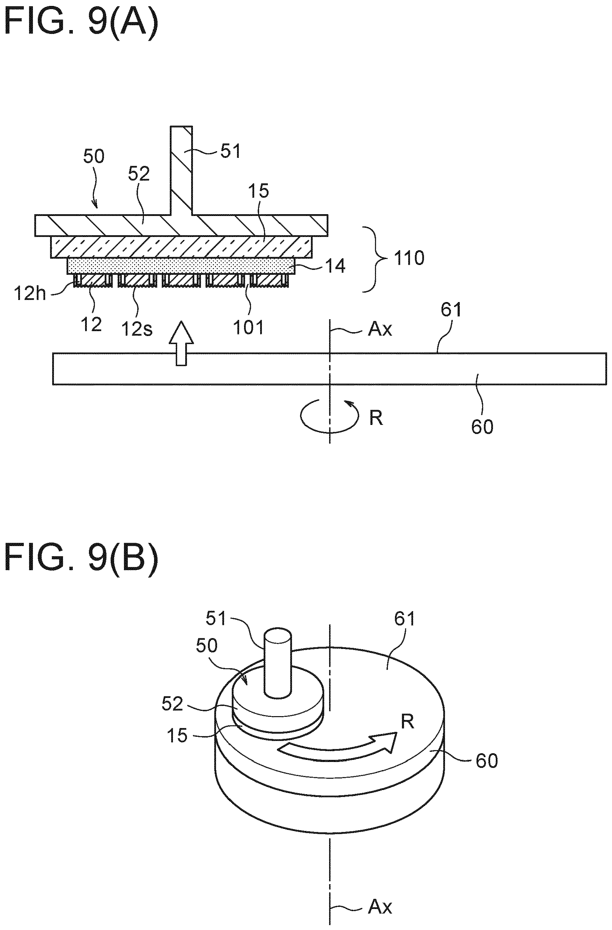

Thus, when the semiconductor layer 12 and the adhesive member 14 receive a load in the stacking direction from a carrier 50 (FIG. 9(A)) of a polishing device in a polishing process which will be described later, for example, the adhesive member 14 is likely to deform and is capable of absorbing stress or the like applied to the semiconductor layer 12.

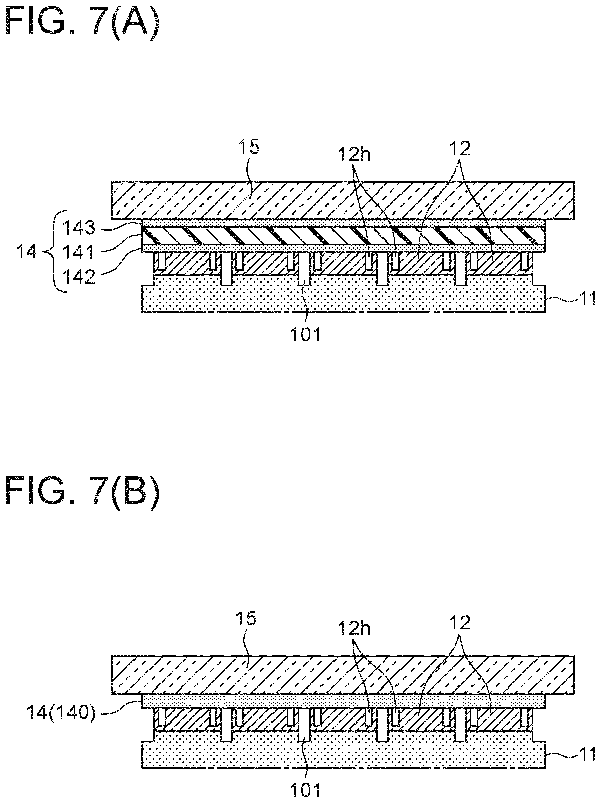

FIGS. 7(A) and 7(B) are cross-sectional views schematically showing configuration examples of the adhesive member 14. In the example shown in FIG. 7(A), the adhesive member 14 is configured as an adhesive sheet. In this case, the adhesive member 14 includes a base member 141, a first adhesive layer 142 provided on a surface of the base member 141 on the semiconductor layer 12 side, and a second adhesive layer 143 provided on a surface of the base member 141 on the glass substrate 15 side.

The base member 141 is desired to have a Young's modulus greater than or equal to 1 GPa. The material of the base member 141 is polyethylene terephthalate, polyethylene naphthalate, polybutylene terephthalate, polyester, polyamide, polycarbonate, polyacetal, polyphenylene sulphide, polysulfone, polyether ketone, or the like, for example.

When the base member 141 is formed of polyester (as an example, polyethylene terephthalate (PET)), the Young's modulus of the base member 141 is 4.6 to 5.1 GPa, for example. The thickness of the base member 141 is 100 µm, for example.

The adhesive layers 142 and 143 are formed of an adhesive whose storage elastic modulus at 50 °C is 0.03 to 0.15 MPa. The thickness of each of the adhesive layers 142 and 143 is 1 µm to 10 µm, for example. The material of the adhesive layers 142 and 143 is an acrylic-based adhesive, a rubber-based adhesive, a vinyl alkyl ether-based adhesive, a silicone-based adhesive, a polyester-based adhesive, a polyamide-based adhesive, a urethane-based adhesive, a fluorine-based adhesive or an epoxy-based adhesive, for example.

In the case where the adhesive member 14 is an adhesive sheet, the thickness of the adhesive member 14 is greater than the thickness of the semiconductor layer 12 (1 µm to 10 µm).

As such an adhesive member 14 (adhesive sheet), an adhesive sheet of the thermal release type can be used, for example. Since the adhesive sheet of the thermal release type exhibits adhesive force at normal temperatures and loses the adhesive force when heated, removal of the adhesive member 14 (step S108) which will be described later can be executed with ease.

In contrast, in the example shown in FIG. 7(B), the adhesive member 14 includes no base member and is formed of one layer that is an adhesive layer 140. The thickness, the material and the storage elastic modulus of the adhesive layer 140 are the same as those of the adhesive layers 142 and 143 shown in FIG. 7(A).

In either case where the adhesive member 14 has the configuration shown in FIG. 7 (A) or 7(B), parts of the adhesive layer can fit into the holes 12h of the semiconductor layer 12. Accordingly, the adhesive force between the adhesive member 14 and the semiconductor layer 12 increases.

### <Process of Peeling off Semiconductor Layer>

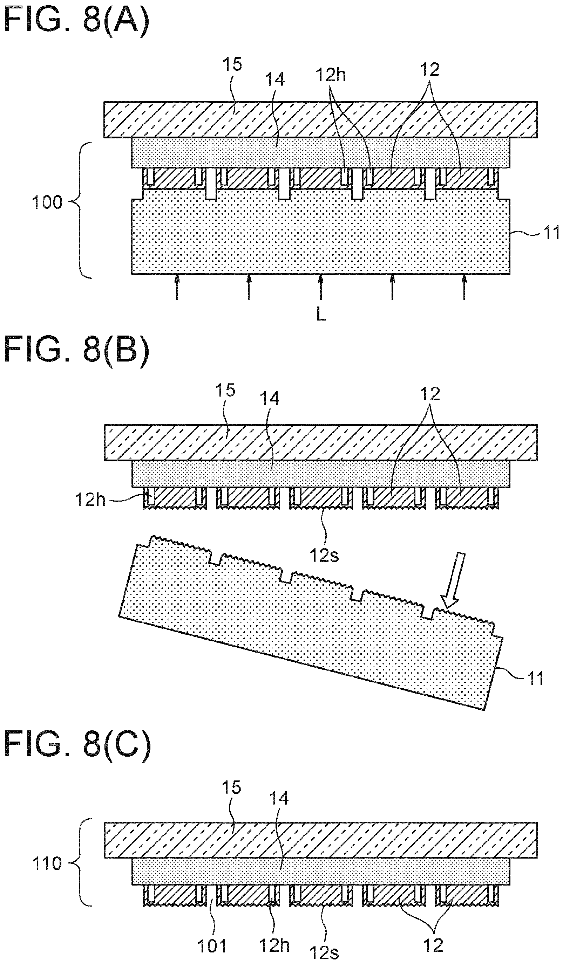

In the subsequent step S105 (FIG. 1), the semiconductor layer 12 is peeled off from the sapphire substrate 11 by applying laser light to the semiconductor layer 12. FIGS. 8(A) to 8(C) are cross-sectional views schematically showing the process of peeling off the semiconductor layers 12 from the sapphire substrate 11.

Since the sapphire substrate 11 transmits the laser light, the laser light (represented by the reference character L) can be applied to the semiconductor layer 12 from the sapphire substrate 11 side of the semiconductor substrate 100 as shown in FIG. 8(A).

The laser light is applied to the interface between the sapphire substrate 11 and the semiconductor layer 12, and the part of the semiconductor layer 12 irradiated with the laser light is heated locally and sublimates. Accordingly, the semiconductor layers 12 peel off from the sapphire substrate 11 as shown in FIG. 8(B). The method of peeling off the semiconductor layers 12 from the sapphire substrate 11 by using laser light as above is referred to as laser lift-off.

By this process, an intermediate structure (pre-polishing structure) 110 in which a plurality of semiconductor layers 12 are supported by the glass substrate 15 via the adhesive member 14 is obtained as shown in FIG. 8(C). The first surface 12s of the semiconductor layer 12 peeled off from the sapphire substrate 11 has great surface roughness due to the laser light irradiation in the peeling process.

### <Process of Polishing Semiconductor Layer>

In the subsequent step S106 (FIG. 1), the semiconductor layers 12 are polished. FIGS. 9(A) and 9(B) are a cross-sectional view and a perspective view schematically showing the process of polishing the semiconductor layers 12.

As shown in FIG. 9(A), the polishing device includes a carrier 50 that holds the intermediate structure 110 and a polishing plate 60 that polishes the semiconductor layers 12 of the intermediate structure 110. The carrier 50 includes, for example, a disk part 52 facing the polishing plate 60 and a support shaft 51 that supports the disk part 52. In the polishing process, the glass substrate 15 of the intermediate structure 110 is fixed to the base of the disk part 52 of the carrier 50.

As shown in FIG. 9(B), the polishing plate 60 has a polishing pad 61 on its surface and rotates in the direction indicated by the arrow R about a rotation axis Ax orthogonal to the surface. It is also possible to rotate the carrier 50 about the support shaft 51 in addition to the rotation of the polishing plate 60.

The carrier 50 is pressed toward the polishing plate 60, and the first surfaces 12s of the semiconductor layers 12 are pressed against the polishing pad 61 of the polishing plate 60. Slurry containing abrasive grains (abradant) is supplied onto the polishing pad 61 of the polishing plate 60.

Chemical mechanical polishing (CMP) is used as the polishing method. CMP is a technique for obtaining an especially smooth polished surface by enhancing the mechanical polishing (surface removal) effect of the relative motion of the slurry and the polishing target object by use of a surface chemical function of the abrasive grains or a function of a chemical component contained in the slurry.

In this first embodiment, the slurry flows in the grooves 101 between adjoining semiconductor layers 12, and thus the polishing effect is enhanced and the polished surface of the semiconductor layer 12 can be smoothed with ease so that the surface roughness becomes less than or equal to 10 nm.

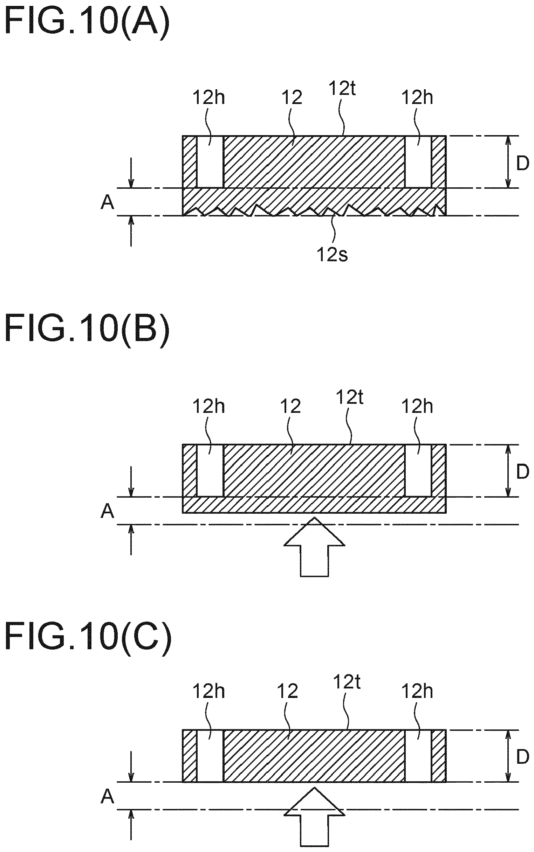

FIGS. 10(A) to 10(C) are cross-sectional views schematically showing a method of controlling the finish thickness of the semiconductor layer 12 in the polishing process. As described earlier, the holes 12h extending from the second surface 12t toward the first surface 12s have been formed in the semiconductor layer 12.

The hole 12h has a depth D not to reach the first surface 12s. The depth D of the hole 12h has been set at a desired finish thickness of the semiconductor layer 12. A distance A from the first surface 12s to the bottom of the hole 12h corresponds to a necessary polishing amount (prescribed amount).

In the polishing process, the rotation of the polishing plate 60 is stopped at a constant time interval. Then, a polishing worker detaches the intermediate structure 110 from the carrier 50 and visually observes the polished surface of each semiconductor layer 12.

As shown in FIG. 10(B), the hole 12h is not exposed to the polished surface until the polishing amount of the semiconductor layer 12 from the first surface 12s reaches a certain amount. In this case, the intermediate structure 110 is reattached to the carrier 50, the rotation of the polishing plate 60 is started, and the polishing is restarted.

The time from the start (restart) of the polishing to the next stoppage of the polishing is determined so that the polishing amount in the time equals a prescribed amount in consideration of revolution speed of the polishing plate 60, a polishing rate, and a target thickness of the semiconductor layer 12.

When the polishing amount reaches a prescribed amount as shown in FIG. 10(C), the hole 12h is exposed to the polished surface. In other words, the hole 12h penetrates the semiconductor layer 12. By ending the polishing at this time point, the finish thickness of the semiconductor layer 12 can be controlled to be equal to the depth D of the hole 12h.

In cases where the semiconductor layer 12 includes holes 12h differing in the depth, it becomes possible to execute the flexible polishing control as follows.

For example, when the depths d1 to d4 of the four holes 12h (reference characters H1 to H4) of each semiconductor layer 12 satisfy d1 < d2 < d3 < d4 as shown in FIG. 4, it is possible to stop the polishing at a time point when the holes 12h having the depth d4 (the hole 12h with the reference character H4) of all the semiconductor layers 12 are exposed. By such a method, the finish thicknesses of all the semiconductor layers 12 can be controlled to be less than or equal to d4.

It is also possible to stop the polishing at a time point when the hole 12h having the depth d4 (the hole 12h with the reference character H4) of all the semiconductor layers 12 are exposed and further the hole 12h having the depth d3 (the hole 12h with the reference character H3) of at least one semiconductor layer 12 is exposed, in consideration of a formation error of the holes 12h or flatness of the polished surfaces. By such a method, the finish thicknesses of all the semiconductor layers 12 can be controlled to be greater than or equal to d3 and less than or equal to d4.

Further, from the viewpoint of preventing excessive polishing, it is also possible to stop the polishing at a time point when the hole 12h having the depth d1 (the hole 12h with the reference character H1) of at least one semiconductor layer 12 is exposed. By such a method, the finish thicknesses of all the semiconductor layers 12 can be controlled to be greater than or equal to d1.

In the polishing process, each semiconductor layers 12 is supported via the adhesive member 14 thicker and softer than the semiconductor layer 12, and thus the load (stress or the like) received by the semiconductor layer 12 at the time of the polishing is reduced and the occurrence of cracking or chipping of the first surface 12s of the semiconductor layer 12 can be prevented.

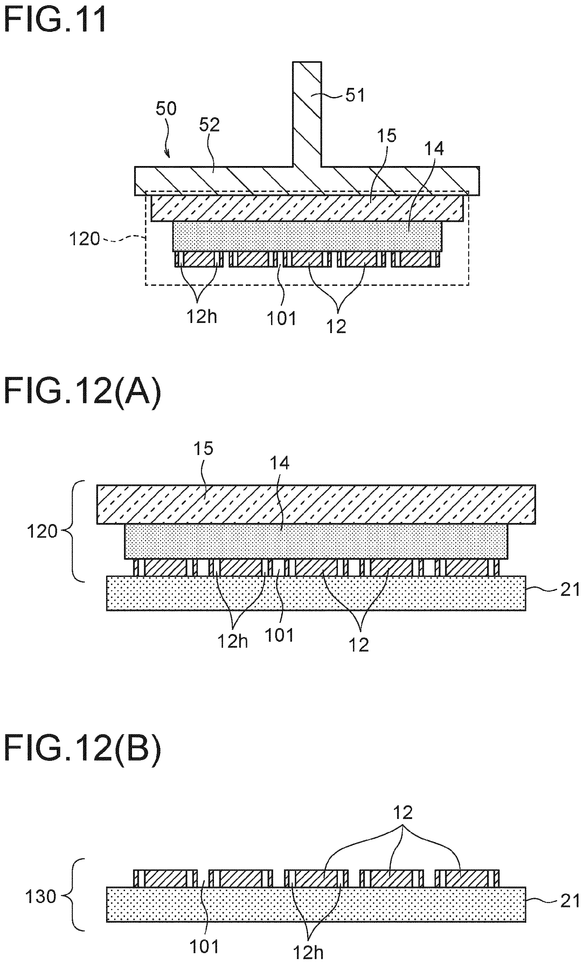

By the above-described polishing process, a semiconductor layer support structure 120 in which a plurality of semiconductor layers 12 are supported by the glass substrate 15 via the adhesive member 14 is obtained as shown in FIG. 11.

FIGS. 12(A) and 12(B) are schematic diagrams showing a process of joining the semiconductor layers 12 to a silicon substrate 21 and a process of removing the adhesive member 14.

### <Process of Joining to Silicon Substrate>

In step S107 (FIG. 1), the polished surfaces of the semiconductor layers 12 of the semiconductor layer support structure 120 detached from the carrier 50 are joined to the silicon substrate 21 as a transfer substrate as shown in FIG. 12(A).

The silicon substrate 21 is a substrate formed of silicon (Si) and is a substrate of a type different from the sapphire substrate 11 as the growth substrate. Since the polished surface of the semiconductor layer 12 has high smoothness with surface roughness less than or equal to 10 nm, the polished surface is joined to the surface of the silicon substrate 21 by intermolecular force.

Incidentally, a wiring pattern or the like may be previously formed on the silicon substrate 21. Further, it is also possible to use a transfer substrate made of a different material instead of the silicon substrate 21.

### <Process of Removing Adhesive Member>

In the subsequent step S108 (FIG. 1), the adhesive member 14 is removed as shown in FIG. 12(B). In the case where the adhesive member 14 is the adhesive sheet of the thermal release type (FIG. 7(A)), the adhesive member 14 can be peeled off by erasing the adhesive force of the adhesive member 14 by heating the adhesive member 14 up to a prescribed temperature. In the case where the adhesive member 14 is the adhesive layer 140 (FIG. 7(B)), the adhesive member 14 can be removed by dissolving the adhesive layer 140 in a solvent, for example.

By the removal of the adhesive member 14, a base substrate 130 in which a plurality of semiconductor layers 12 are arrayed in a grid on the silicon substrate 21 is obtained. The semiconductor layer 12 is referred to also as a semiconductor element.

The semiconductor layer 12 of the base substrate 130 is made into an LED, for example, by forming the mesa structure by means of patterning and forming electrodes or a wiring pattern. By this process, a micro-LED display device in which LEDs are arrayed in a grid on the silicon substrate 21 is formed, for example.

Further, an outer peripheral part of the semiconductor layer 12 including the holes 12h may be removed at the time of the patterning. In this case, a central part of the semiconductor layer 12 on the inner side relative to the holes 12h is made into an LED, for example.

### <Effect of First Embodiment>

As described above, the manufacturing method of the semiconductor element in the first embodiment includes the process of forming a plurality of semiconductor layers 12 on the sapphire substrate 11, the joining process of joining the second surfaces 12t of the plurality of semiconductor layers 12 to the glass substrate 15 (retention member) via the adhesive member 14, the peeling process of peeling off the plurality of semiconductor layers 12 from the sapphire substrate 11 by irradiating the first surfaces 12s of the plurality of semiconductor layers 12 with laser light, and the polishing process of polishing the first surfaces 12s of the semiconductor layers 12. Among the plurality of semiconductor layers 12, at least one semiconductor layer 12 includes the hole 12h (polishing indication part) extending from the second surface 12t toward the first surface 12s. In the polishing process, the polishing is executed until the hole 12h is exposed to the polished surface.

Therefore, the finish thickness of the semiconductor layer 12 can be controlled at the target thickness by previously forming the hole 12h having a depth corresponding to the target thickness of the semiconductor layer 12 and executing the polishing until the hole 12h is exposed to the polished surface.

Especially, by using the hole 12h extending from the second surface 12t toward the first surface 12s of the semiconductor layer 12 as the polishing indication part, the polishing indication part can be implemented with a simple configuration.

Further, in cases where the semiconductor layer 12 includes a plurality of holes 12h differing in the depth, it becomes possible to execute flexible polishing control by selecting the time point to stop the polishing among time points when the holes 12h having various depths are respectively exposed. Thus, excessive polishing can be prevented.

The semiconductor substrate 100 (FIG. 5(B)) as an intermediate product includes the sapphire substrate 11, the plurality of semiconductor layers 12, the adhesive member 14, and the glass substrate 15 as a retention member, and at least one semiconductor layer 12 includes the hole 12h. Therefore, by separating the semiconductor layers 12 of the semiconductor substrate 100 from the sapphire substrate 11 and polishing the semiconductor layers 12, the semiconductor layers 12 can be joined to the silicon substrate 21.

The semiconductor layer support structure 120 (FIG. 11) as an intermediate product includes the plurality of semiconductor layers 12, the adhesive member 14, and the glass substrate 15 as the retention member, and at least one semiconductor layer 12 includes the hole 12h. Therefore, it is possible to polish the semiconductor layers 12 of the semiconductor layer support structure 120 and thereafter join the semiconductor layers 12 to the silicon substrate 21.

### (Second Embodiment)

Next, a second embodiment will be described below. The second embodiment differs from the first embodiment in that the semiconductor layers 12 include dummy parts D1 to D8, the holes 12h are formed in the dummy parts D1 to D8, and the adhesive member 14 is provided with through holes 14h.

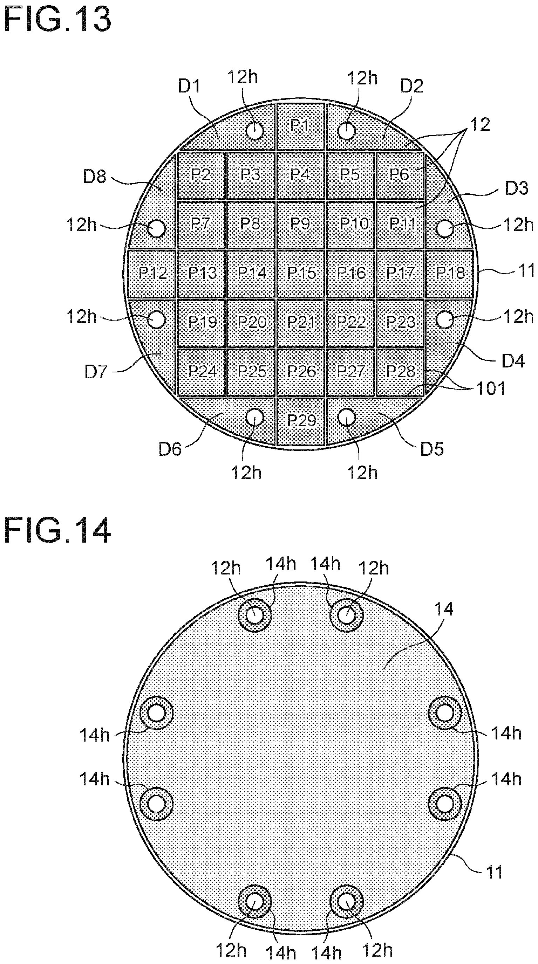

FIG. 13 is a plan view showing the semiconductor layers 12 separated (singulated) in the step S102 in FIG. 1. The semiconductor layers 12 include the dummy parts D1 to D8 along the outer circumference of the sapphire substrate 11 (wafer) in addition to the chip parts P1 to P29 described in the first embodiment. The dummy parts D1 to D8 are parts not used as LEDs or the like among the semiconductor layers 12.

The arrangement of the chip parts P1 to P29 is as described earlier with reference to FIG. 3. The dummy parts D1 and D2 are respectively formed on both sides of the chip part P1 in a row direction. The dummy parts D3 and D4 are respectively formed on both sides of the chip part P18 in a column direction. The dummy parts D5 and D6 are respectively formed on both sides of the chip part P29 in the row direction. The dummy parts D7 and D8 are respectively formed on both sides of the chip part P12 in the column direction.

Incidentally, the arrangement of the dummy parts of the semiconductor layers 12 is not limited to the example shown in FIG. 13. It is sufficient that at least one dummy part is formed on the sapphire substrate 11 and on the outer circumferential side relative to the chip parts.

In this second embodiment, not the chip parts P1 to P29 but the dummy parts D1 to D8 of the semiconductor layers 12 are respectively provided with holes 12h. Each of the dummy parts D1 to D8 includes one hole 12h. Incidentally, it is also possible that each of the dummy parts D1 to D8 includes two or more holes 12h. Further, it is unnecessary that all of the dummy parts D1 to D8 include the hole 12h; it is sufficient that at least one dummy part includes the hole 12h.

The hole 12h extends from the second surface 12t toward the first surface 12s of the semiconductor layer 12 as described in the first embodiment. The extending direction of the hole 12h is the direction orthogonal to the first surface 12s and the second surface 12t, for example. While the cross-sectional shape of the hole 12h is the circular shape, for example, the cross-sectional shape may also be a different shape.

FIG. 14 is a plan view showing the adhesive member 14 covering the semiconductor layers 12. The adhesive member 14 includes the through holes 14h at positions corresponding to the holes 12h of the dummy parts D1 to D8 of the semiconductor layers 12. The through hole 14h penetrates the adhesive member 14 in a thickness direction of the adhesive member 14 (i.e., direction orthogonal to the first surface 12s and the second surface 12t of the semiconductor layer 12).

The cross-sectional area of the through hole 14h is larger than the cross-sectional area of the hole 12h of the semiconductor layer 12. While the cross-sectional shape of the through hole 14h is a circular shape, for example, the cross-sectional shape can also be a different shape.

### <Process of Forming Semiconductor Thin-film Layer to Process of Peeling off Semiconductor Layer>

The process of forming the semiconductor thin-film layer 12a, the process of separating (singulating) the semiconductor thin-film layer 12a into the semiconductor layers 12, the process of forming the holes 12h, the process of joining the semiconductor layers 12 to the glass substrate 15 and the process of peeling off the semiconductor layers 12 from the sapphire substrate 11 are as described in the steps S101 to S105 (FIG. 1) in the first embodiment.

However, the through holes 14h shown in FIG. 14 have previously been formed in the adhesive member 14 that joins the semiconductor layers 12 to the glass substrate 15.

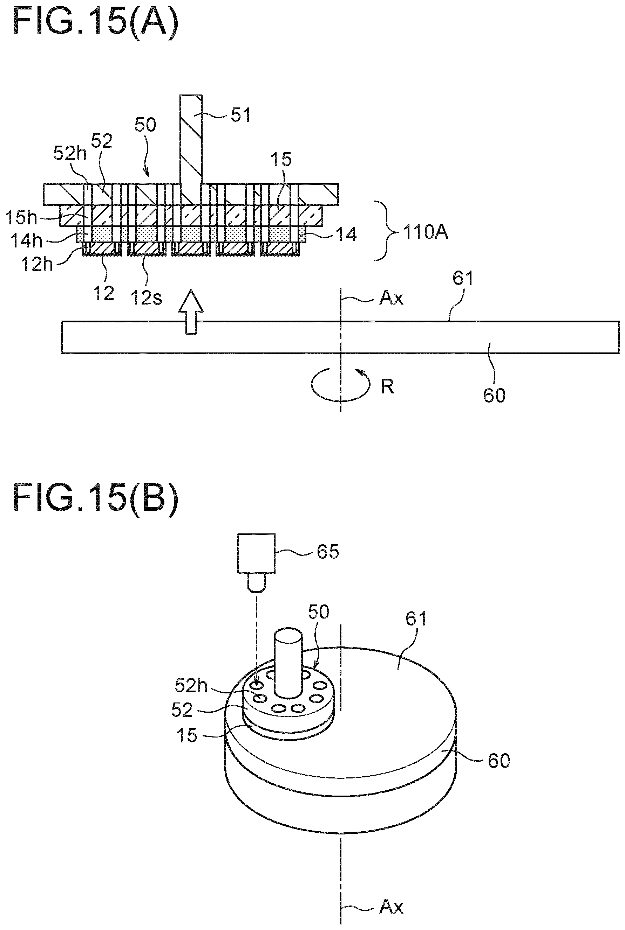

By the peeling of the sapphire substrate 11, an intermediate structure (pre-polishing structure) 110A including a plurality of semiconductor layers 12, the adhesive member 14 and the glass substrate 15 is formed (see FIG. 15(A) which will be explained later).

### <Process of Polishing Semiconductor Layer>

FIGS. 15(A) and 15(B) are a cross-sectional view and a perspective view schematically showing a process of polishing the semiconductor layers 12. As shown in FIG. 15(A), in the polishing process, the glass substrate 15 of the intermediate structure 110A is fixed to the carrier 50 of the polishing device. The polishing device and the polishing method are as described in the first embodiment.

In the glass substrate 15, through holes 15h have been formed at positions overlapping with the holes 12h of the semiconductor layers 12. Further, in the disk part 52 of the carrier 50, through holes 52h have been formed at positions overlapping with the holes 12h of the semiconductor layers 12. Namely, the adhesive member 14, the glass substrate 15 and the carrier 50 (the disk part 52) include the through holes 14h, 15h and 52h at positions overlapping with the holes 12h of the semiconductor layers 12.

Therefore, it is possible in the polishing process to check whether the hole 12h has penetrated the semiconductor layer 12 or not (whether the hole 12h has been exposed to the polished surface or not) via the through holes 14h, 15h and 52h. Namely, whether the hole 12h has penetrated the semiconductor layer 12 or not can be checked without the need of detaching the intermediate structure 110A from the carrier 50.

For example, by providing the polishing device with an optical device 65 such as an optical sensor or a camera as shown in FIG. 15(B), whether the hole 12h has penetrated the semiconductor layer 12 or not can be detected via the through holes 14h, 15h and 52h.

The operation of detecting whether the hole 12h has penetrated the semiconductor layer 12 or not (by use of the optical device 65) may be executed either after stopping the rotation of the polishing plate 60 at a constant time interval similarly to the first embodiment or while maintaining the rotation of the polishing plate 60.

Incidentally, the glass substrate 15 does not necessarily have to be provided with the through holes 15h since the glass substrate 15 transmits light. Further, in cases where the disk part 52 of the carrier 50 is formed of a material that transmits light, the disk part 52 does not necessarily have to be provided with the through holes 52h.

### <Process of Joining to Silicon Substrate - Process of Removing Adhesive>

The process of joining the semiconductor layers 12 after the polishing to the silicon substrate 21 and the process of removing the adhesive member 14 are as described in the first embodiment.

By these processes, a base substrate in which a plurality of semiconductor layers 12 are arrayed in a grid on the silicon substrate 21 is obtained. The configuration of the base substrate is similar to that of the base substrate 130 (FIG. 12(B)) in the first embodiment.

The semiconductor layer 12 of the base substrate is patterned as described in the first embodiment and thereby made into an LED, for example. At this stage, the dummy parts D1 to D8 of the semiconductor layers 12 are removed.

Also in the manufacturing method in the second embodiment, a semiconductor substrate and a semiconductor layer support structure similar to the semiconductor substrate 100 (FIG. 5(B)) and the semiconductor layer support structure 120 (FIG. 11) in the first embodiment are produced. Difference is that the semiconductor layers 12 of the semiconductor substrate and the semiconductor layer support structure in the second embodiment include the dummy parts D1 to D8.

Incidentally, while the dummy parts D1 to D8 of the semiconductor layers 12 are provided with the hole 12h in this example, it is also possible to provide at least one of the chip parts P1 to P29 of the semiconductor layers 12 with the hole 12h. Also in this case, if the adhesive member 14, the glass substrate 15 and the carrier 50 are provided with the through holes 14h, 15h and 52h, whether the hole 12h has penetrated the semiconductor layer 12 or not (i.e., whether the hole 12h has been exposed from the polished surface or not) can be judged in a state where the intermediate structure 110A is attached to the carrier 50.

### <Effect of Second Embodiment>

As described above, in the second embodiment, the adhesive member 14, the glass substrate (retention member) 15 and the carrier 50 include the through holes 14h, 15h and 52h at positions overlapping with the holes 12h of the semiconductor layers 12. Therefore, it becomes possible to make the judgment on whether the hole 12h has penetrated the semiconductor layer 12 or not in a state where the intermediate structure 110A is attached to the carrier 50. Accordingly, the finish thickness of the semiconductor layer 12 can be controlled with greater ease.

### (Third Embodiment)

Next, a third embodiment will be described below. The third embodiment differs from the first embodiment in that a support 13 is provided between the semiconductor layer 12 and the adhesive member 14.

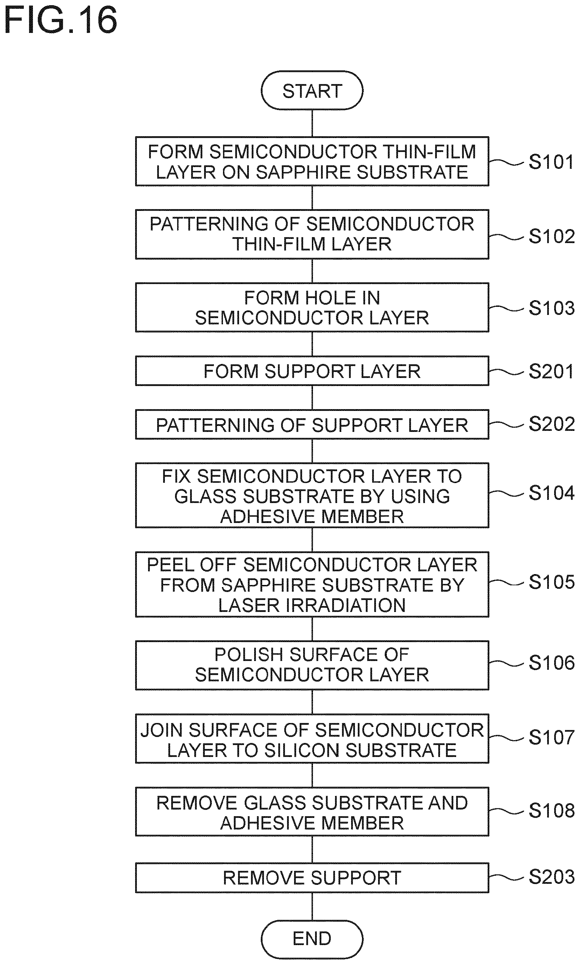

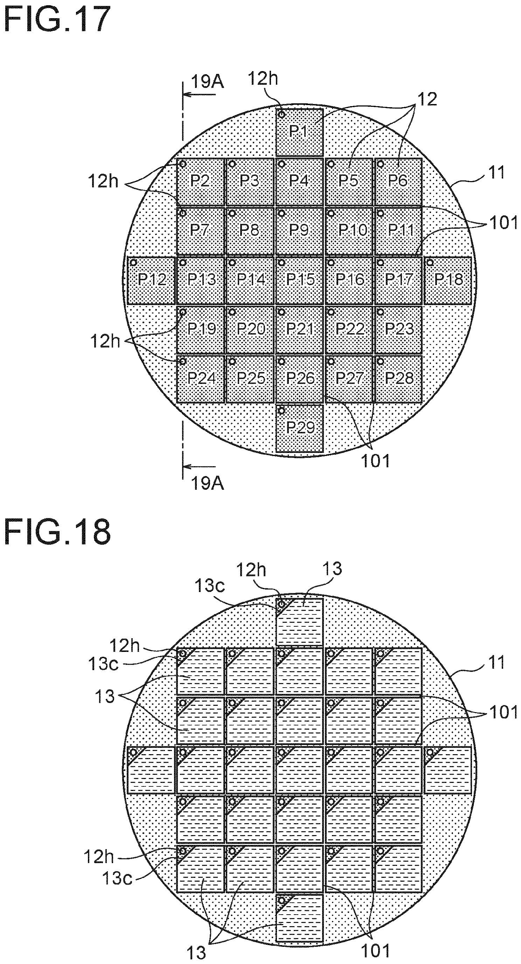

FIG. 16 is a flowchart showing a manufacturing method of a semiconductor element in the third embodiment. FIG. 17 is a plan view showing the semiconductor layers 12 separated (singulated) on the sapphire substrate 11. FIG. 18 is a plan view showing the supports 13 formed on the semiconductor layers 12.

As shown in FIG. 17, in the third embodiment, the hole 12h is formed in the vicinity of one corner (i.e., in one of four corner parts) of each semiconductor layer 12.

Further, as shown in FIG. 18, in the third embodiment, the support 13 is formed on each semiconductor layer 12. While the support 13 has a two-dimensional shape similar to that of the semiconductor layer 12, the support 13 has a cutout part 13c at a position overlapping with the corner part where the hole 12h of the semiconductor layer 12 is formed. Namely, the support 13 has a shape not closing the hole 12h of the semiconductor layer 12.

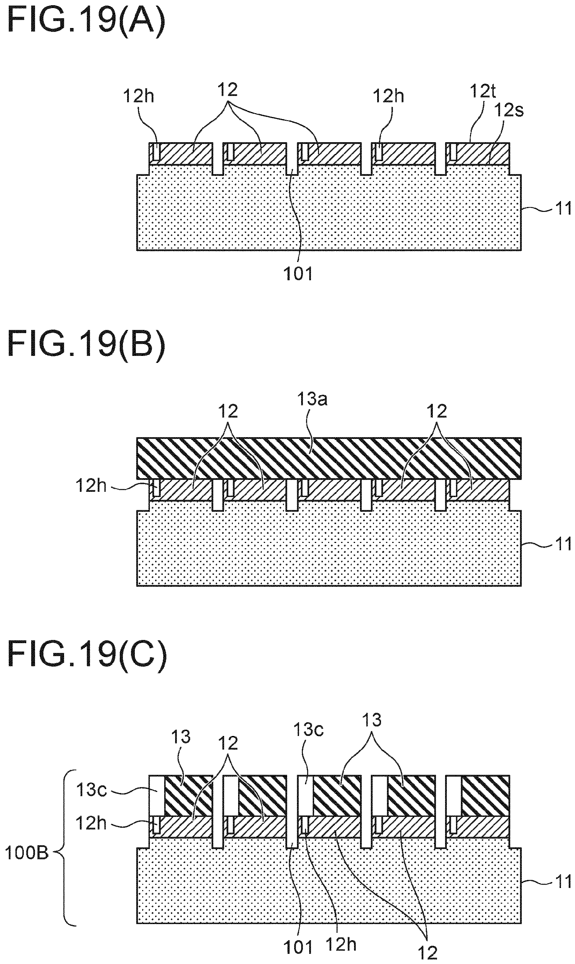

FIGS. 19(A) to 19(C) are diagrams schematically showing a process of forming the holes 12h in the semiconductor layers 12, a process of forming a support layer 13a and a process of separating (singulating) the support layer 13a. FIGS. 19(A) to 19(C) correspond to cross-sectional views taken along the line 19A - 19A shown in FIG. 17.

The processes of forming the semiconductor thin-film layer 12a on the sapphire substrate 11 and the process of separating (singulating) the semiconductor thin-film layer 12a into a plurality of semiconductor layers 12 (S101, S102) are as described in the first embodiment. Further, the process of forming the hole 12h in the semiconductor layer 12 as shown in FIG. 19(A) (S103) is as described in the first embodiment.

### <Process of Forming Support Layer>

In the subsequent step S201 (FIG. 16), the support layer 13a is formed to cover the semiconductor layers 12 on the sapphire substrate 11 as shown in FIG. 19(B). The support layer 13a is formed of a resin. More specifically, the support layer 13a is formed of a negative-type photoresist based on "EPON_SU-8" being an epoxy resin.

### <Process of Singulating Support Layer>

In the subsequent step S202 (FIG. 16), as shown in FIG. 19(C), the support layer 13a is patterned by means of photolithography and thereby separated (singulated) into a plurality of supports 13 similarly to the semiconductor layers 12. Namely, the supports 13 are separated from each other by the grooves 101 similarly to the semiconductor layers 12.

By this process, a semiconductor substrate 100B in which a plurality of islands (stacked structures), each made by stacking the semiconductor layer 12 and the support 13, are formed on the sapphire substrate 11.

The thickness of the semiconductor layer 12 is in a range of 1 µm to 10 µm, for example. On the other hand, the thickness of the support 13 is greater than (preferably, twice or more of) the thickness of the semiconductor layer 12, and is in a range of 10 µm to 100 µm, for example.

Further, the Young's modulus of the semiconductor layer 12 is 200 GPa, for example. On the other hand, the Young's modulus of the support 13 is lower than the Young's modulus of the semiconductor layer 12, and is 2.7 GPa, for example. In other words, the support 13 is softer and more likely to deform than the semiconductor layer 12.

### <Process of Joining to Glass Substrate>

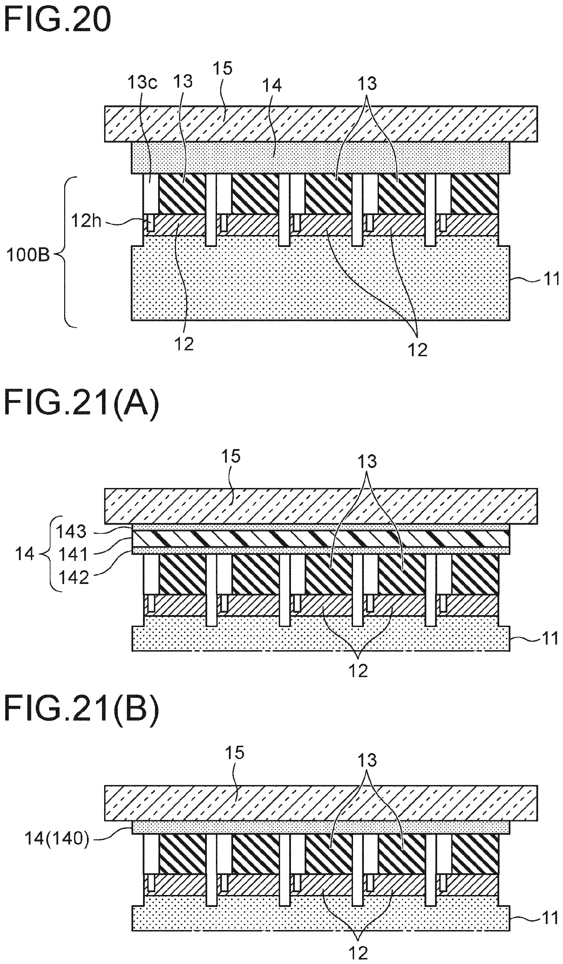

In the subsequent step S104 (FIG. 16), the supports 13 on the semiconductor layers 12 are joined to the glass substrate 15 via the adhesive member 14. FIG. 20 is a cross-sectional view schematically showing a state in which the supports 13 have been joined to the glass substrate 15 via the adhesive member 14. The adhesive member 14 is softer than the semiconductor layer 12 and the support 13.

FIGS. 21(A) and 21(B) are cross-sectional views schematically showing configuration examples of the adhesive member 14. In the example shown in FIG. 21(A), the adhesive member 14 is configured as an adhesive sheet and includes the base member 141, the first adhesive layer 142 provided on the surface of the base member 141 on the support 13 side, and the second adhesive layer 143 provided on the surface of the base member 141 on the glass substrate 15 side. The thicknesses, the materials and the Young's moduli of the base member 141 and the adhesive layers 142 and 143 are as described in the first embodiment.

In contrast, in the example shown in FIG. 21(B), the adhesive member 14 includes no base member and is formed of one layer that is the adhesive layer 140. The thickness, the material and the storage elastic modulus of the adhesive layer 140 are as described in the first embodiment.

### <Process of Peeling off Semiconductor Layer>

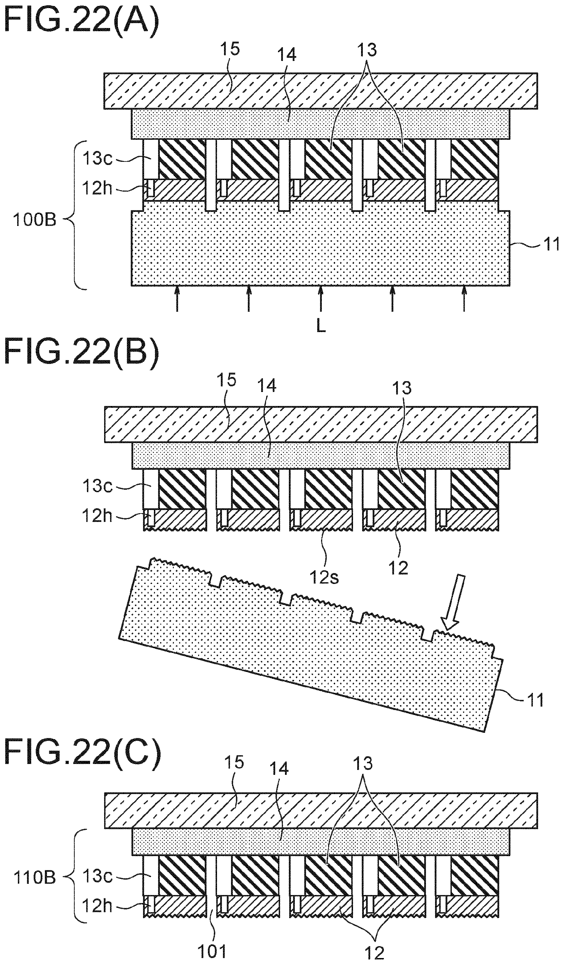

In the subsequent step S105 (FIG. 16), the semiconductor layers 12 are peeled off from the sapphire substrate 11 by applying laser light to the semiconductor layers 12. FIGS. 22(A) to 22(C) are cross-sectional views schematically showing the process of peeling off the semiconductor layers 12 from the sapphire substrate 11.

As shown in FIG. 22(A), the laser light is applied to the semiconductor layer 12 from the sapphire substrate 11 side of the semiconductor substrate 100B. Accordingly, the semiconductor layers 12 peel off from the sapphire substrate 11 as shown in FIG. 22 (B) .

By the peeling of the sapphire substrate 11, an intermediate structure (pre-polishing structure) 110B including a plurality of islands each including the semiconductor layer 12 and the support 13, the adhesive member 14 and the glass substrate 15 is obtained as shown in FIG. 22(C).

### <Process of Polishing Semiconductor Layer>

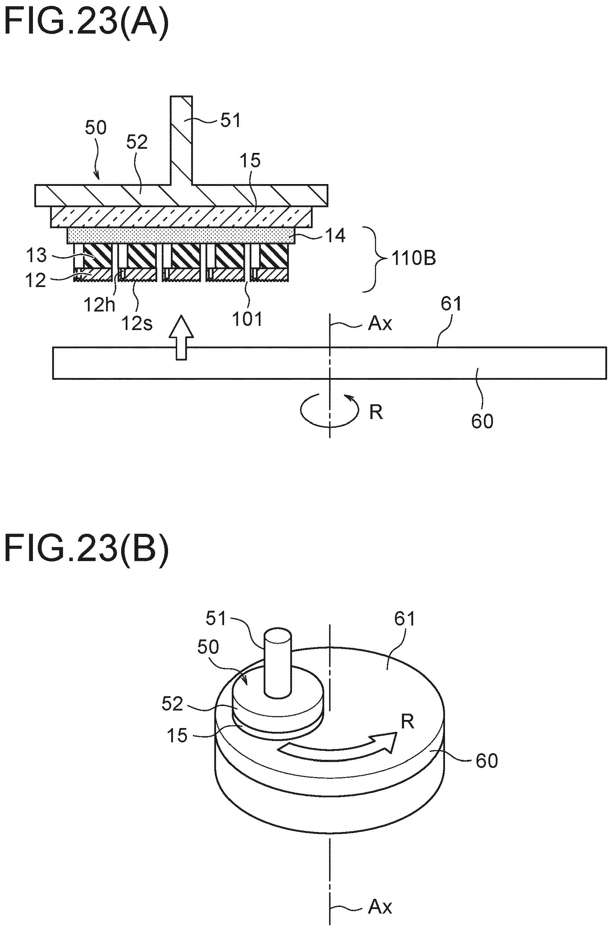

In the subsequent step S106 (FIG. 16), the semiconductor layers 12 are polished. FIGS. 23(A) and 23(B) are a cross-sectional view and a perspective view schematically showing the process of polishing the semiconductor layers 12.

As shown in FIG. 23(A), in the polishing process, the glass substrate 15 of the intermediate structure 110B is fixed to the carrier 50 of the polishing device. The polishing device and the polishing method are as described in the first embodiment.

In the polishing process, as described in the first embodiment, the rotation of the polishing plate 60 is stopped at a constant time interval, and the polishing worker detaches the intermediate structure 110B from the carrier 50 and visually observes the polished surfaces of the semiconductor layers 12. By this method, the finish thickness of the semiconductor layers 12 can be controlled precisely.

In the polishing process, the slurry flows in the grooves 101 between the islands each including the semiconductor layer 12 and the support 13, and thus the slurry is fed to the first surfaces 12s of all the semiconductor layers 12 and the polishing effect is enhanced. Accordingly, the polished surface of the semiconductor layer 12 can be smoothed with ease so that the surface roughness becomes less than or equal to 10 nm.

Further, since the semiconductor layers 12 is supported via the support 13 having a greater thickness and a lower Young's modulus than the semiconductor layer 12, the load acting on the semiconductor layer 12 at the time of the polishing is reduced and the occurrence of the cracking or chipping of the first surface 12s of the semiconductor layer 12 can be prevented.

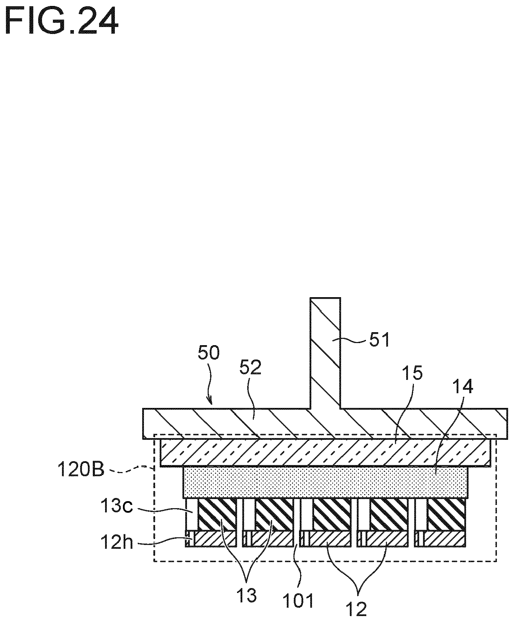

By the above-described polishing process, a semiconductor layer support structure 120B including a plurality of islands each including the semiconductor layer 12 and the support 13, the adhesive member 14 and the glass substrate 15 is obtained as shown in FIG. 24.

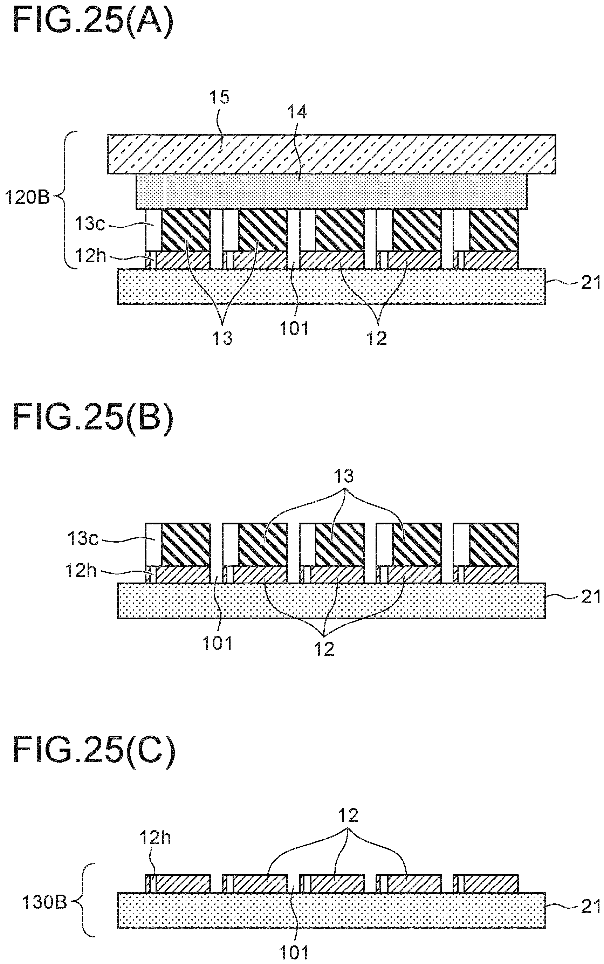

FIGS. 25(A), 25(B) and 25(C) are schematic diagrams showing a process of joining the semiconductor layers 12 to the silicon substrate 21, a process of removing the adhesive member 14 and a process of removing the support 13.

### <Process of Joining to Silicon Substrate>

In the subsequent step S107 (FIG. 16), the polished surfaces of the semiconductor layers 12 of the semiconductor layer support structure 120B detached from the carrier 50 are joined to the silicon substrate 21 as the transfer substrate as shown in FIG. 25(A). The polished surfaces of the semiconductor layers 12 are joined to the surface of the silicon substrate 21 by intermolecular force.

### <Process of Removing Adhesive Member>

In the subsequent step S108 (FIG. 16), the adhesive member 14 is removed as shown in FIG. 25 (B) . In the case where the adhesive member 14 is the adhesive sheet of the thermal release type (FIG. 21(A)), the adhesive member 14 can be peeled off by erasing the adhesive force of the adhesive member 14 by heating the adhesive member 14 up to a prescribed temperature. In the case where the adhesive member 14 is the adhesive layer 140 (FIG. 21(B)), the adhesive member 14 can be removed by dissolving the adhesive layer 140 in a solvent, for example.

### <Process of Removing Support>

In the subsequent step S203 (FIG. 16), the support 13 is removed as shown in FIG. 25(C). The support 13 can be removed by dissolving the support 13 in an organic solvent, for example.

By the removal of the supports 13, a base substrate 130B in which a plurality of semiconductor layers 12 are arrayed in a grid on the silicon substrate 21 is obtained. The semiconductor layer 12 is referred to also as the semiconductor element. The semiconductor layer 12 of the base substrate 130B is patterned as described in the first embodiment and thereby made into an LED, for example.

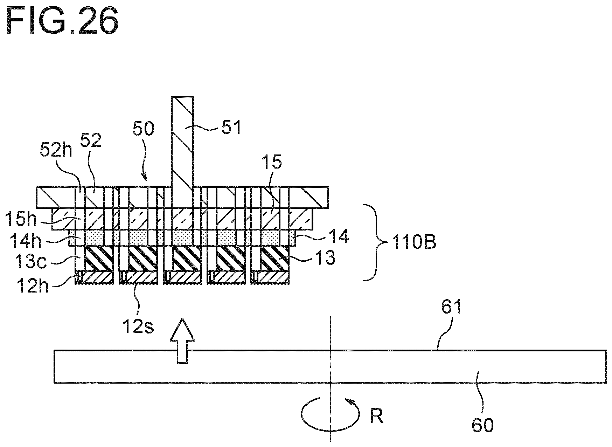

Incidentally, as shown in FIG. 26, the adhesive member 14, the glass substrate 15 and the disk part 52 of the carrier 50 may also be provided with the through holes 14h, 15h and 52h at positions overlapping with the holes 12h of the semiconductor layers 12. With such a configuration, whether the hole 12h has penetrated the semiconductor layer 12 or not can be checked by using the optical device 65 (FIG. 15(B)) described in the second embodiment.

### <Effect of Third Embodiment>

As described above, in the third embodiment, in addition to the effects described in the first embodiment, the semiconductor layer 12 is supported via the support 13, and thus the stress or the like applied to the semiconductor layer 12 in the polishing process can be absorbed by the support 13 and the load acting on the semiconductor layer 12 can be reduced. Accordingly, the occurrence of the cracking or chipping of the polished surface of the semiconductor layer 12 can be inhibited.

### (Fourth Embodiment)

Next, a fourth embodiment will be described below. The fourth embodiment differs from the first embodiment in that a semiconductor layer 32 includes a cutout part 32c instead of the hole 12h.

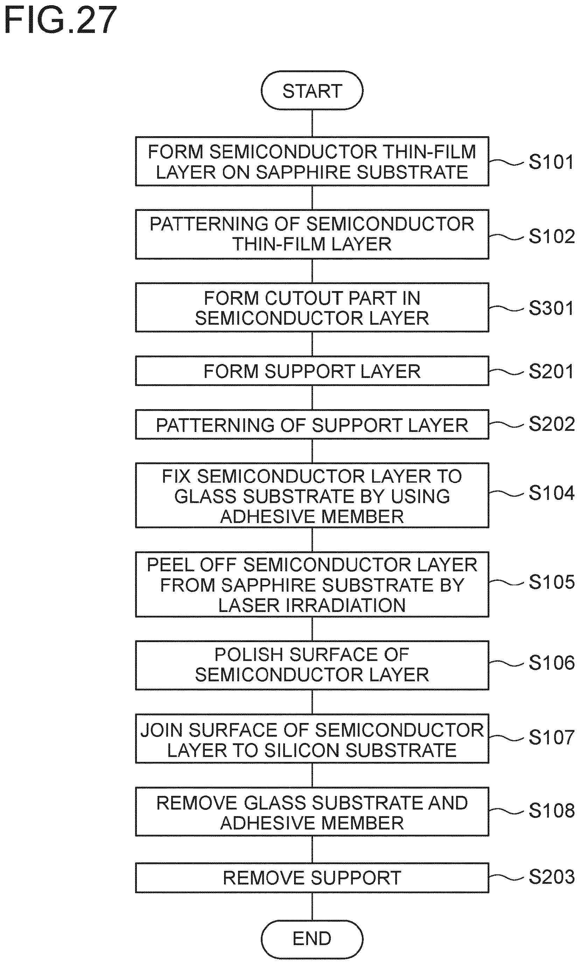

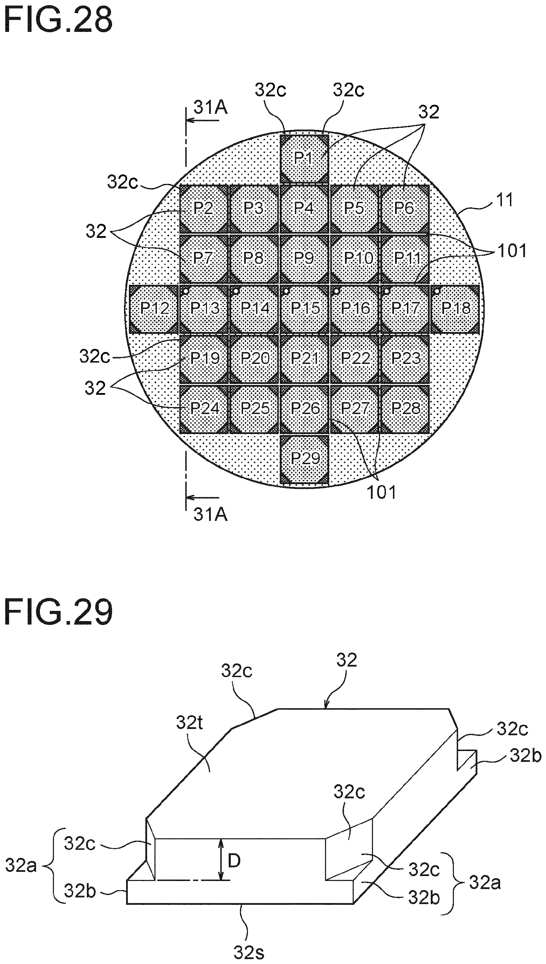

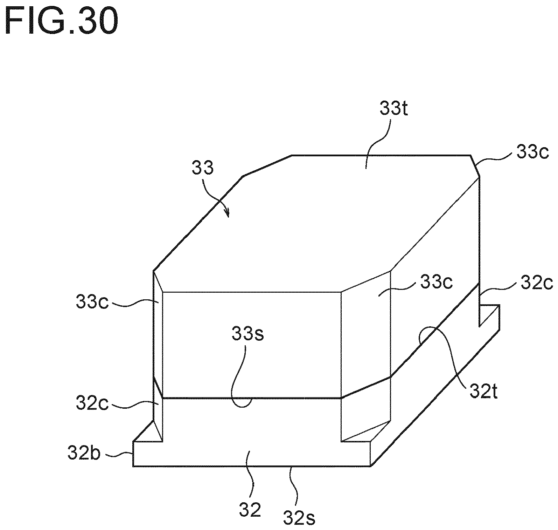

FIG. 27 is a flowchart showing a manufacturing method of a semiconductor element in the fourth embodiment. FIG. 28 is a plan view schematically showing the semiconductor layers 32 separated on the sapphire substrate 11. FIG. 29 is a perspective view schematically showing the shape of the semiconductor layer 32. FIG. 30 is a perspective view schematically showing a state in which a support 33 has been formed on the semiconductor layer 32.

### <Process of Forming Semiconductor Thin-film Layer to Process of Singulation>

The processes of forming the semiconductor thin-film layer on the sapphire substrate 11 and patterning the semiconductor thin-film layer and thereby separating (singulating) the semiconductor thin-film layer into the semiconductor layers 32 (steps S101 and S102 in FIG. 27) are as described in the first embodiment. The semiconductor layer 32 is referred to also as the semiconductor thin film (or the semiconductor thin film piece).

As shown in FIG. 28, the semiconductor layers 32 are separated in a grid pattern by the grooves 101 extending in two directions orthogonal to each other. The shape of the semiconductor layer 32 is a quadrangular shape, more specifically, a square shape with each side 1 mm to 10 mm long. However, the shape of the semiconductor layer 32 is not limited to the square shape but may also be a rectangular shape or a different shape.

As shown in FIG. 29, the semiconductor layer 32 has a first surface 32s facing the sapphire substrate 11 and a second surface 32t on the opposite side. The semiconductor layer 32 has a shape obtained by cutting away four corner parts of a quadrangle. Namely, the semiconductor layer 32 has four cutout parts 32c.

While the cutout part 32c as the polishing indication part extends from the second surface 32t toward the first surface 32s, the cutout part 32c does not reach the first surface 32s. The extending direction of the cutout part 32c is a direction orthogonal to the first surface 32s and the second surface 32t, for example.

Further, a base part 32b is formed on the first surface 32s side of the cutout part 32c. The base part 32b projects outward from the cutout part 32c on a plane parallel to the first surface 32s. The cutout part 32c and the base part 32b are also referred to collectively as a step part 32a.

As shown in FIG. 30, the support 33 has a first surface 33s facing the semiconductor layer 32 and a second surface 33t on the opposite side. The two-dimensional shape of the support 33 is the same as the two-dimensional shape of the semiconductor layer 32 (excluding the base parts 32b).

The support 33 has a shape obtained by cutting away four corner parts of a quadrangle. Namely, the support 33 has four cutout parts 33c. The cutout part 33c extends from the first surface 33s to the second surface 33t. The cutout parts 33c of the support 33 are situated at positions overlapping with the cutout parts 32c of the semiconductor layer 32.

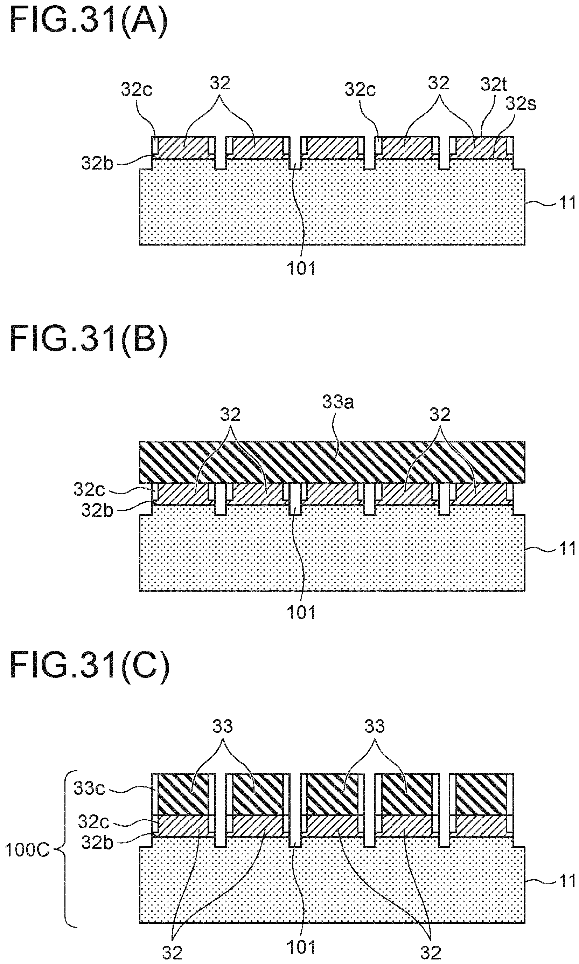

FIGS. 31(A) to 31(C) are diagrams schematically showing a process of forming the cutout parts 32c in the semiconductor layer 32, a process of forming a support layer 33a and a process of separating (singulating) the support layer 33a. FIGS. 31(A) to 31(C) correspond to cross-sectional views taken along the line 31A - 31A shown in FIG. 28.

### <Process of Forming Cutout Parts>

In the subsequent step S301 (FIG. 27), as shown in FIG. 31(A), the cutout parts 32c are formed in the semiconductor layers 32 on the sapphire substrate 11 by means of photolithography, for example. The depth of the cutout part 32c is less than the thickness of the semiconductor layer 32. Therefore, the base part 32b is formed under the cutout part 32c.

Incidentally, while all the semiconductor layers 32 (P1 to P29) shown in FIG. 28 include the cutout parts 32c in this example, it is sufficient that at least one semiconductor layer 32 includes the cutout parts 32c. Further, the one semiconductor layer 32 does not need to include four cutout parts 32c, and it is sufficient that the one semiconductor layer 32 includes at least one cutout part 32c.

### <Process of Forming Support Layer to Process of Singulation>

In the subsequent step S201 (FIG. 27), the support layer 33a is formed to cover the semiconductor layers 32 as shown in FIG. 31(B). The thickness and the material of the support layer 33a are the same as those of the support layer 13a in the third embodiment.

In the subsequent step S202 (FIG. 27), as shown in FIG. 31(C), the support layer 33a is patterned by means of photolithography and thereby separated (singulated) into a plurality of supports 33 similarly to the semiconductor layers 32. In this case, the cutout parts 33c are formed in the supports 33.

By this process, a semiconductor substrate 100C in which a plurality of islands (stacked structures), each made by stacking the semiconductor layer 32 and the support 33, are formed on the sapphire substrate 11 is formed.

### <Process of Joining to Glass Substrate>

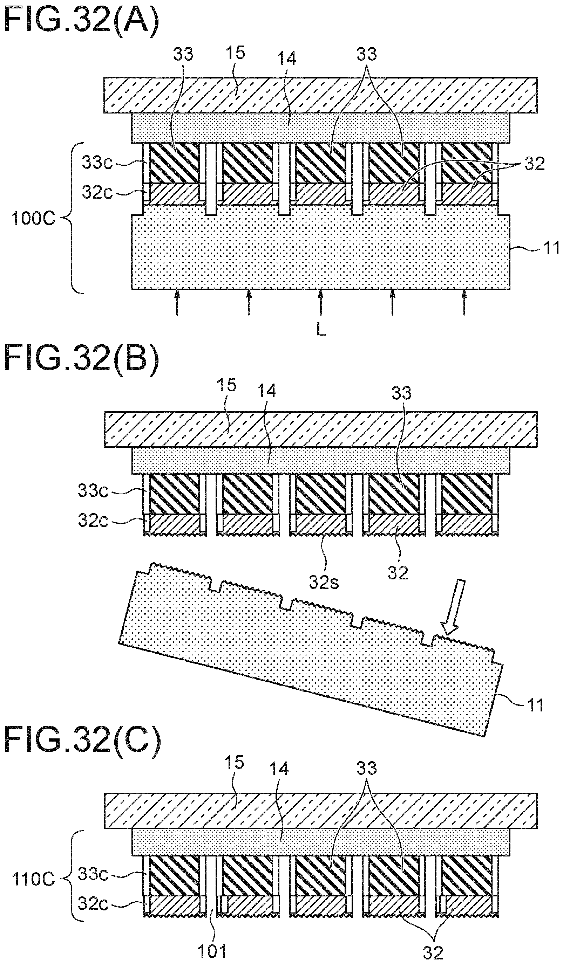

In the subsequent step S104 (FIG. 27), the supports 33 on the semiconductor layers 32 are joined to the glass substrate 15 via the adhesive member 14 (FIG. 32(A) which will be explained later) as described in the third embodiment. The adhesive member 14 is as described in the first embodiment.

### <Process of Peeling off Semiconductor Layer>

In the subsequent step S105 (FIG. 27), the semiconductor layers 32 are separated from the sapphire substrate 11 by applying laser light to the semiconductor layer 32. FIGS. 32 (A) to 32(C) are cross-sectional views schematically showing the process of peeling off the semiconductor layers 32 from the sapphire substrate 11.

As shown in FIG. 32(A), the laser light is applied to the semiconductor layer 32 from the sapphire substrate 11 side of the semiconductor substrate 100C. Accordingly, the semiconductor layers 32 peel off from the sapphire substrate 11 as shown in FIG. 32(B).

Consequently, an intermediate structure (pre-polishing structure) 110C including a plurality of islands each including the semiconductor layer 32 and the support 33, the adhesive member 14 and the glass substrate 15 is obtained as shown in FIG. 32(C).

### <Process of Polishing Semiconductor Layer>

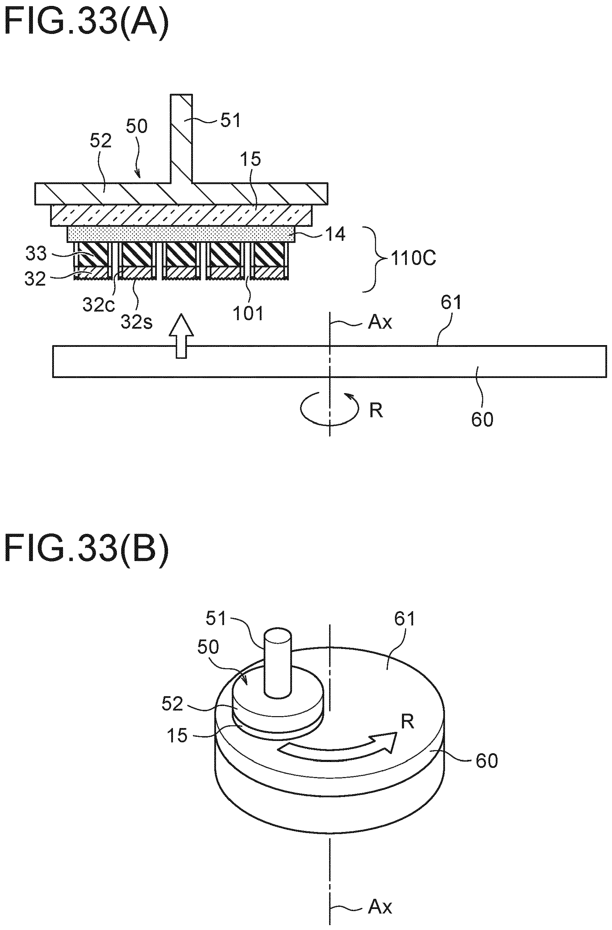

In the subsequent step S106 (FIG. 27), the semiconductor layers 32 are polished. FIGS. 33(A) and 33(B) are a cross-sectional view and a perspective view schematically showing the process of polishing the semiconductor layers 32.

As shown in FIG. 33(A), in the polishing process, the glass substrate 15 of the intermediate structure 110C is fixed to the carrier 50 of the polishing device. The polishing device and the polishing method are as described in the first embodiment.

The semiconductor layer 32 is provided with the cutout parts 32c formed to extend from the second surface 32t toward the first surface 32s. The cutout part 32c has a depth not to reach the first surface 32s. The depth of the cutout part 32c has been set at a desired finish thickness of the semiconductor layer 32.

In the polishing process, the rotation of the polishing plate 60 is stopped at a constant time interval as described in the first embodiment. Then, the polishing worker detaches the intermediate structure 110C from the carrier 50 and visually observes the polished surfaces of the semiconductor layers 32.

The cutout part 32c is not exposed to the polished surface until the polishing amount of the semiconductor layer 32 from the first surface 32s reaches a certain amount. In this case, the intermediate structure 110C is reattached to the carrier 50, the rotation of the polishing plate 60 is started, and the polishing is restarted.

The time from the start (restart) of the polishing to the next stoppage of the polishing is determined so that the polishing amount in the time equals a prescribed amount in consideration of the revolution speed of the polishing plate 60, the polishing rate, and the target thickness of the semiconductor layer 32.

When the polishing amount reaches a prescribed amount, the cutout part 32c is exposed to the polished surface. In other words, the base part 32b disappears and the cutout part 32c penetrates the semiconductor layer 32. By ending the polishing at this time point, the finish thickness of the semiconductor layer 32 can be controlled to be equal to the depth of the cutout part 32c.

Incidentally, it is also possible to provide the semiconductor layer 32 with cutout parts 32c differing in the depth. In this case, flexible polishing control becomes possible as described in the first embodiment with reference to FIG. 4.

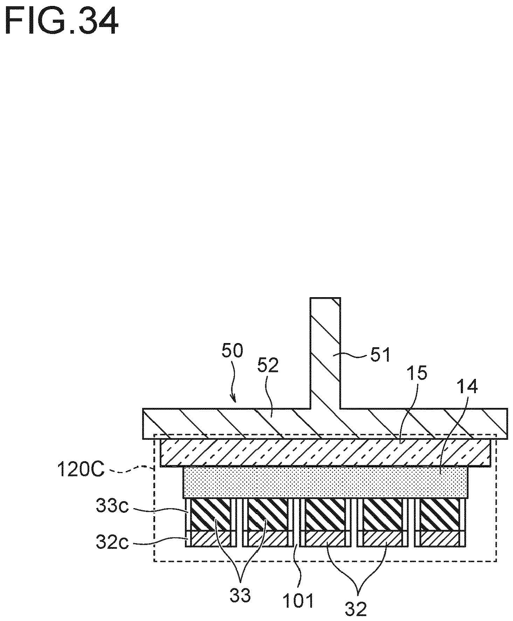

By this process, a semiconductor layer support structure 120C including a plurality of islands each including the semiconductor layer 32 and the support 33, the adhesive member 14 and the glass substrate 15 is obtained as shown in FIG. 34.

### <Process of Joining to Silicon Substrate to Process of Removing Support>

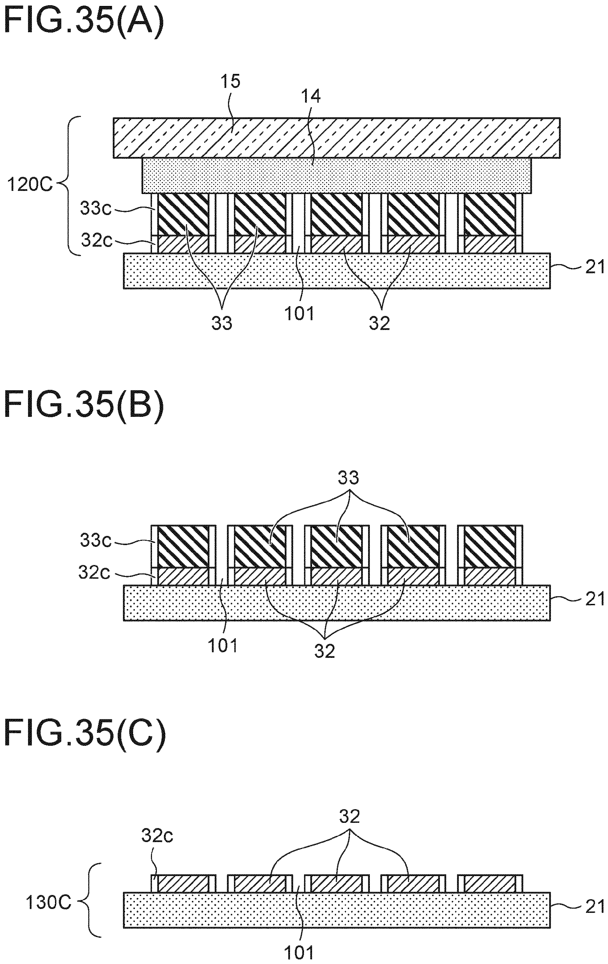

FIGS. 35(A), 35(B) and 35(C) are schematic diagrams showing a process of joining the semiconductor layers 32 to the silicon substrate 21, a process of removing the adhesive member 14 and a process of removing the support 33.

In step S107 (FIG. 27), the polished surfaces of the semiconductor layers 32 of the semiconductor layer support structure 120C detached from the carrier 50 are joined to the silicon substrate 21 as the transfer substrate as shown in FIG. 35(A) .

In the subsequent step S108 (FIG. 27), the adhesive member 14 is removed as shown in FIG. 35(B). The method of removing the adhesive member 14 is as described in the first embodiment.

In the subsequent step S203 (FIG. 27), the support 33 is removed as shown in FIG. 35 (C). The method of removing the support 33 is as described in the third embodiment.

By the removal of the supports 33, a base substrate 130C in which a plurality of semiconductor layers 32 are arrayed in a grid on the silicon substrate 21 is obtained. The semiconductor layer 32 is referred to also as the semiconductor element. The semiconductor layer 32 of the base substrate 130C is patterned as described in the first embodiment and thereby made into an LED, for example.

Incidentally, while the cutout part 32c in the fourth embodiment is formed to cut away a corner part of the semiconductor layer 32 in this example, the cutout part 32c is not limited to such a configuration. For example, the cutout part 32c may also be formed on a side face of the semiconductor layer 32 as a groove (for example, U-shaped groove or V-shaped groove) extending from the second surface 32t toward the first surface 32s.

Further, the adhesive member 14, the glass substrate 15 and the disk part 52 of the carrier 50 may also be provided with the through holes 14h, 15h and 52h (see FIG. 15(A)) overlapping with the cutout parts 32c of the semiconductor layers 12. With such a configuration, whether the cutout part 32c has penetrated the semiconductor layer 32 or not can be checked by using the optical device 65 (FIG. 15(B)) described in the second embodiment.

### <Effect of Fourth Embodiment>

As described above, in the fourth embodiment, the semiconductor layer 32 includes the cutout part 32c as the polishing indication part extending from the second surface 32t toward the first surface 32s. Therefore, the finish thickness of the semiconductor layer 32 can be controlled at the target thickness by previously forming the cutout part 32c having a depth equal to the target thickness of the semiconductor layer 32 and executing the polishing until the cutout part 32c is exposed to the polished surface (i.e., until the base part 32b disappears).

While preferred embodiments have been described specifically above, the present disclosure is not limited to the above-described embodiments and a variety of improvements or modifications are possible. For example, it is also possible to make a combined use of the hole 12h described in the first embodiment and the cutout part 32c described in the fourth embodiment.

The present disclosure is applicable to a manufacturing method of a semiconductor element such as an LED and to a semiconductor layer support structure and a semiconductor substrate used for the manufacture of semiconductor elements.

### DESCRIPTION OF REFERENCE CHARACTERS

11: sapphire substrate (growth substrate), 12: semiconductor layer, 12a: semiconductor thin-film layer, 12h: hole (polishing indication part), 12s: first surface, 12t: second surface, 13: support, 13a: support layer, 13c: cutout part, 14: adhesive member, 14h: through hole, 15: glass substrate (retention member), 15h: through hole, 21: silicon substrate (transfer substrate), 32: semiconductor layer, 32a: step part, 32b: base part, 32c: cutout part, 32s: first surface, 32t: second surface, 33: support, 33a: support layer, 33c: cutout part (polishing indication part), 33s: first surface, 33t: second surface, 50: carrier, 52: disk part, 52h: through hole, 60: polishing plate, 65: optical device, 100, 100B, 100C: semiconductor substrate, 101: groove, 110, 110B, 110C: intermediate structure (pre-polishing structure), 120, 120B, 120C: semiconductor layer support structure, 130, 130B, 130C: base substrate, 140: adhesive layer, 141: base member, 142: first adhesive layer, 143: second adhesive layer.

## Claims

1. A manufacturing method of a semiconductor element, comprising:
a process of forming a plurality of semiconductor layers (12) on a sapphire substrate (11), each of the plurality of semiconductor layers (12) having a first surface (12s) on the sapphire substrate (11) side and a second surface (12t) on the opposite side;
a joining process of joining the second surfaces (12t) of the plurality of semiconductor layers (12) to a retention member (15) via an adhesive member (14);
a peeling process of peeling off the plurality of semiconductor layers (12) from the sapphire substrate (11) by irradiating the first surfaces (12s) of the plurality of semiconductor layers (12) with laser light; and
a polishing process of polishing the first surfaces (12s) of the plurality of semiconductor layers (12),
wherein at least one semiconductor layer (12) among the plurality of semiconductor layers (12) includes a polishing indication part (12h, 32b) extending from the second surface (12t) toward the first surface (12s), and
wherein the polishing in the polishing process is executed until the polishing indication part (12h, 32b) is exposed to the polished surface.

2. The manufacturing method of a semiconductor element according to claim 1, wherein the polishing indication part (12h, 32b) is a hole (12h) formed from the second surface (12t) toward the first surface (12s), and
wherein the polishing in the polishing process is executed until the hole (12h) is exposed to the polished surface.

3. The manufacturing method of a semiconductor element according to claim 2, wherein the at least one semiconductor layer (12) has a quadrangular shape in a plane parallel to the first surface (12s), and
wherein the hole (12h) is formed in the vicinity of a corner part of the quadrangular shape.

4. The manufacturing method of a semiconductor element according to claim 1, wherein the polishing indication part (32b) includes a cutout part (32c) formed from the second surface (32t) toward the first surface (32s),
wherein a base part (32b) is formed on the first surface (32s) side of the cutout part (32c), and
wherein the polishing in the polishing process is executed until the cutout part (32c) is exposed to the polished surface.

5. The manufacturing method of a semiconductor element according to claim 4, wherein the at least one semiconductor layer (12) has a quadrangular shape in a plane parallel to the first surface (12s), and
wherein the cutout part (32c) is formed to cut away a corner part of the quadrangular shape.

6. The manufacturing method of a semiconductor element according to claim 1 or 2, wherein the at least one semiconductor layer (12) includes a plurality of polishing indication parts (12h, 32b) differing from each other in a distance of extension from the second surface (12t).

7. The manufacturing method of a semiconductor element according to claim 1 or 2, wherein the polishing in the polishing process is executed until surface roughness becomes less than or equal to 10 nm.

8. The manufacturing method of a semiconductor element according to claim 1 or 2, wherein in the polishing process, the retention member (15) to which the plurality of semiconductor layers (12) are joined via the adhesive member (14) is held by a carrier (50) of a polishing device, and
wherein each of the adhesive member (14), the retention member (15) and the carrier (50) include a through hole (14h, 15, 52h) at a position overlapping with the polishing indication part (12h, 32b) of the at least one semiconductor layer (12).

9. The manufacturing method of a semiconductor element according to claim 1 or 2, further comprising a process of forming supports (13) on the plurality of semiconductor layers (12),
wherein in the polishing process, the supports (13) are joined to the retention member (15) via the adhesive member (14) and the retention member (15) is held by a carrier (50) of a polishing device.

10. A semiconductor layer support structure (120, 120B, 120C) comprising:
a plurality of semiconductor layers (12) each having a first surface (12s) and a second surface (12t) on the opposite side; and
a retention member (15) to which the second surfaces (12t) of the plurality of semiconductor layers (12) are joined via an adhesive member (14),
wherein at least one of the plurality of semiconductor layers (12) includes a polishing indication part (12h, 32b) extending from the second surface (12t) toward the first surface (12s).

11. The semiconductor layer support structure (120, 120B, 120C) according to claim 10, wherein the polishing indication part (12h, 32b) is a hole (12h) extending from the second surface (12t) toward the first surface (12s).

12. The semiconductor layer support structure (120, 120B, 120C) according to claim 10 or 11, wherein the polishing indication part (32b) includes a cutout part (32c) extending from the second surface (32t) toward the first surface (32s), and
wherein a base part (32b) is formed on the first surface (32s) side of the cutout part (32c).

13. A semiconductor substrate (100, 100B, 100C) comprising:
a sapphire substrate (11); and
a plurality of semiconductor layers (12) formed on the sapphire substrate (11) and each having a first surface (12s) on the sapphire substrate (11) side and a second surface (12t) on the opposite side,
wherein at least one of the plurality of semiconductor layers (12) includes a polishing indication part (12h, 32b) extending from the second surface (12t) toward the first surface (12s).

14. The semiconductor substrate (100, 100B, 100C) according to claim 13, wherein the polishing indication part (12h, 32b) is a hole (12h) extending from the second surface (12t) toward the first surface (12s).

15. The semiconductor substrate (100, 100B, 100C) according to claim 13 or 14, wherein the polishing indication part (32b) includes a cutout part (32c) extending from the second surface (32t) toward the first surface (32s), and
wherein a base part (32b) is formed on the first surface (32s) side of the cutout part (32c).
